# EUROPEAN PATENT SPECIFICATION

(11) **EP 4 583 098 B1**
(45) Date of publication and mention of the grant of the patent: **26.08.2026**
(21) Application number: 22957372.0
(22) Date of filing: 30.08.2022
(51) Int. Cl.: G10H 1/18, G06F 3/02, G10H 1/055, G10H 1/34, H03K 17/97, H03K 17/972

(54) **KEYBOARD DEVICE AND METHOD FOR DETECTING KEY PRESS INFORMATION**
TASTATURVORRICHTUNG UND VERFAHREN ZUR ERKENNUNG VON TASTENDRUCKINFORMATIONEN
DISPOSITIF CLAVIER, ET PROCÉDÉ POUR DÉTECTER DES INFORMATIONS DE PRESSION DE TOUCHE

(43) Date of publication of application: 09.07.2025
(73) Proprietor: Roland Corporation, Hamamatsu-shi, Shizuoka 431-2103 (JP)
(72) Inventor: HISAMITSU, Hajime, Hamamatsu-shi, Shizuoka 431-1304 (JP); SAKASHITA, Toshihiko, Hamamatsu-shi, Shizuoka 431-1304 (JP)
(74) Representative: Becker, Eberhard
(86) International application number: PCT/JP2022/032676
(87) International publication number: WO 2024/047773

(56) References cited:
- WO-A1-2021/100475
- CN-A- 114 651 302
- JP-A- 2021 081 615
- JP-A- H0 367 299
- JP-A- H02 293 796
- JP-Y1- S5 417 373
- JP-Y1- S5 438 199

## Description

### Technical Field

The present invention relates to a keyboard device and a key depression information detecting method, and more particularly relates to a keyboard device and a key depression information detecting method capable of accurately detecting key depression information while suppressing an increase in weight and cost.

### Related Art

There is known a technique for detecting the depth and speed of key depression (hereinafter referred to as "key depression information") with a contactless sensor when a key is depressed. For example, Patent Literature 1 describes a technique in which a coil 57 that generates a magnetic field when a current flows therethrough is formed on a substrate 56, and a metal plate 55 (conductor) facing the coil 57 is fixed to a key 41. According to this technique, the current flowing through the coil 57 changes and consequently the magnetic field changes due to the displacement of the metal plate 55 relative to the coil 57 during key depression, which enables the key depression information to be detected based on the change of the current.

### Citation List

### Patent Literature

[Patent Literature 1] Japanese Patent Application Laid-Open No. 03-048295 (for example, lines 7 to 18 in the upper left column of page 9, and FIG. 29).

JPS 5417373 Y1 discloses a keyboard device configured to detect key depression information through magnetic field detection.

### SUMMARY OF INVENTION

### Problems to be Solved by the Invention

The conventional technique described above has the problem that the metal plate 55 is formed relatively thick, leading to an increase in weight and cost. Regarding this problem, if the metal plate 55 is simply formed thin, the magnetic flux tends to concentrate at the end of the metal plate 55 (lower end in FIG. 29 of Patent Literature 1). Since the concentration of the magnetic flux causes the output value of the sensor to become unstable, the key depression information cannot be detected with high accuracy.

The present invention has been made to solve the above-described problems, and an object of the present invention is to provide a keyboard device and a key depression information detecting method that are capable of accurately detecting key depression information while suppressing an increase in weight and cost.

### Means for Solving the Problems

In order to achieve the above, a keyboard device according to the present invention includes: a coil generating a magnetic field; a displacement member having an outer surface and displaced at a position facing the coil during key depression; and a conductor provided on the displacement member. The conductor includes: a facing portion covering the outer surface of the displacement member to face the coil during key depression; and a front surface portion connected to the facing portion and covering an outer surface of the displacement member which is directed to a front side in a displacement direction of the displacement member.

A key depression information detecting method according to the present invention is provided for detecting key depression information in a keyboard device, which includes a coil generating a magnetic field, a displacement member having an outer surface and displaced at a position facing the coil during key depression, and a conductor provided on the displacement member. The conductor includes a facing portion covering the outer surface of the displacement member to face the coil during key depression, and a front surface portion connected to the facing portion and covering an outer surface of the displacement member which is directed to a front side in a displacement direction of the displacement member. The key depression information detecting method includes detecting the key depression information by displacing the conductor relative to the coil through displacement of the displacement member.

### BRIEF DESCRIPTION OF DRAWINGS

FIG. 1 is a cross-sectional view of the keyboard device according to the first embodiment.
FIG. 2A is a partially enlarged cross-sectional view of the keyboard device in the part IIa of FIG. 1, and FIG. 2B is a partially enlarged cross-sectional view of the keyboard device along the line IIb-IIb in FIG. 2A.
FIG. 3A is a partially enlarged cross-sectional view of the keyboard device showing a state where the white key is depressed from the state in FIG. 2A, and FIG. 3B is a partially enlarged cross-sectional view of the keyboard device showing a state where the white key is depressed to the terminal position from the state in FIG. 3A.
FIG. 4A is a graph showing the relationship between the key stroke amount and the sensor output,
FIG. 4B is a partially enlarged cross-sectional view of the keyboard device in which the part IVb in FIG. 3A is enlarged, and FIG. 4C is a partially enlarged cross-sectional view of the keyboard device along the line IVc-IVc in FIG. 4B.
FIG. 5A is a schematic diagram of the magnetic field (lines of magnetic force) when a thin detected portion is formed only on the bottom surface of the displacement member, and FIG. 5B is a schematic diagram of the magnetic field (lines of magnetic force) when the detected portion is formed on the bottom surface and the front surface of the displacement member.
FIG. 6 is an exploded perspective view of the keyboard device.
FIG. 7A is a partially enlarged front view of the holder, FIG. 7B is a partially enlarged top view of the holder viewed in the direction of the arrow VIIb in FIG. 7A, and FIG. 7C is a front view of the holder showing a state where the holder is bent.
FIG. 8A is a perspective view showing how the shaft portion of the holder is slid along the guide groove, and FIG. 8B is a perspective view showing a state where the holder with the displacement member attached thereto is fixed to the substrate.
FIG. 9A is a side view of the displacement member showing the first modified example, and FIG. 9B is a graph showing the relationship between the stroke amount of key depression and the sensor output when the displacement member of the first modified example is used.
FIG. 10A is a side view of the displacement member showing the second modified example, and
FIG. 10B is a graph showing the relationship between the stroke amount of key depression and the sensor output when the displacement member of the second modified example is used.
FIG. 11 is a cross-sectional view of the keyboard device according to the second embodiment.
FIG. 12 is an exploded perspective view of the keyboard device.
FIG. 13A is a partially enlarged cross-sectional view of the keyboard device showing how the shaft portion of the holder is fitted into the insertion hole of the white key, and FIG. 13B is a partially enlarged cross-sectional view of the keyboard device showing a state where the shaft portion of the holder is fitted into the insertion hole of the white key.
FIG. 14A is a partially enlarged cross-sectional view of the keyboard device in which the part XIVa in FIG. 11 is enlarged, and FIG. 14B is a partially enlarged cross-sectional view of the keyboard device showing a state where the white key is depressed to the terminal position from the state in FIG. 14A.
FIG. 15A is a partially enlarged cross-sectional view of the keyboard device according to the third embodiment, and FIG. 15B is a partially enlarged cross-sectional view of the keyboard device along the line XVb-XVb in FIG. 15A.
FIG. 16A is a partially enlarged cross-sectional view of the keyboard device showing a state where the white key is depressed from the state in FIG. 15A, and FIG. 16B is a partially enlarged cross-sectional view of the keyboard device showing a state where the white key is depressed to the terminal position from the state in FIG. 16A.

### DESCRIPTION OF EMBODIMENTS

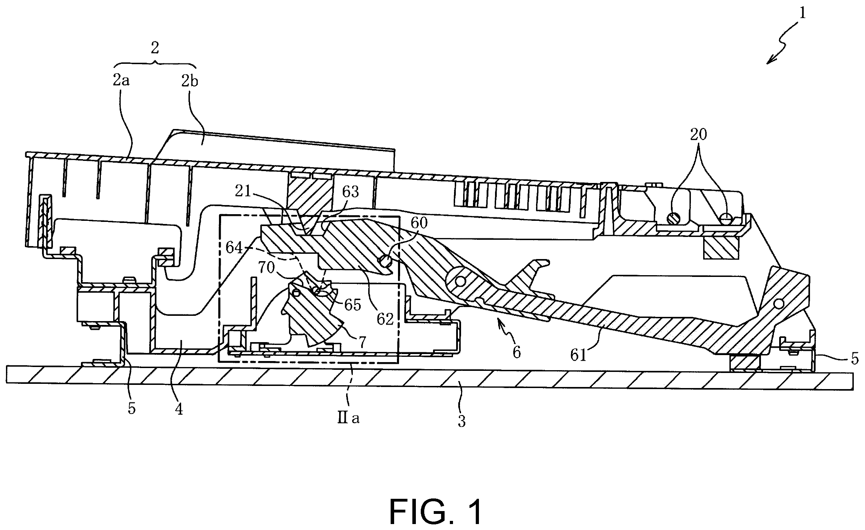

Preferred embodiments will be described hereinafter with reference to the accompanying drawings. First, the overall configuration of a keyboard device 1 of the first embodiment will be described with reference to FIG. 1. FIG. 1 is a cross-sectional view of the keyboard device 1 according to the first embodiment.

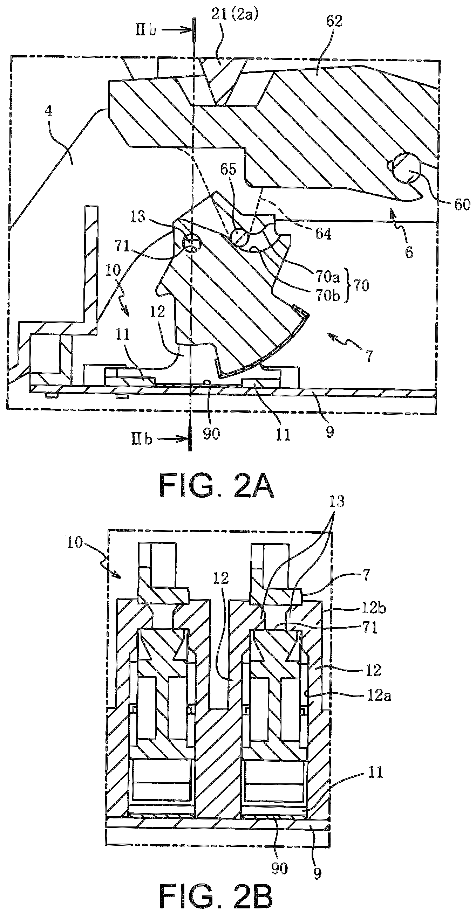

FIG. 1 shows a cross section cut along a plane that is orthogonal to a scale direction of the keyboard device 1 (direction in which a plurality of keys 2 are arranged). Furthermore, in the following description, the front side as viewed from the player (left side in FIG. 1) is referred to as the front side of the keyboard device 1, the side opposite thereto (right side in FIG. 1) is referred to as the rear side, and the direction in which a plurality of keys 2 are arranged (direction perpendicular to the paper surface of FIG. 1) is referred to as the scale direction. Also, in FIG. 1, a protrusion portion 64 of a hammer 6 is illustrated by a broken line (the same applies to FIG. 2A and FIG. 2B and subsequent figures).

As shown in FIG. 1, the keyboard device 1 is a keyboard instrument (electronic piano) including a plurality of (88 in this embodiment) keys 2. The keys 2 are composed of a plurality of (52 in this embodiment) white keys 2a for playing natural tones and a plurality of (36 in this embodiment) black keys 2b for playing derived tones, and the white keys 2a and the black keys 2b are arranged in the scale direction (direction perpendicular to the paper surface of FIG. 1).

The keyboard device 1 includes a bottom plate 3 for supporting the white keys 2a and the black keys 2b. The bottom plate 3 is made of synthetic resin, steel plate, or the like and formed in a flat plate shape extending in the scale direction. A chassis 4 made of resin is supported on the upper surface of the bottom plate 3. The chassis 4 is fixed to the bottom plate 3 through channel members 5 at both the front and rear ends of the chassis 4.

A rotating shaft 20 of the key 2 is provided on the upper surface of the rear end side (right side in FIG. 1) of the chassis 4, and the rear end portion of each key 2 is rotatably (swingably) supported by the chassis 4 through the rotating shaft 20. The hammer 6 and a displacement member 7 that interlock with the rotation of the key 2 are provided below the key 2.

The detailed configuration of the white key 2a will be described hereinafter, and this configuration is substantially the same for the black key 2b. Thus, the black key 2b also has the functions and effects brought by the configuration of the white key 2a, which will be described below.

The hammer 6 is rotatably supported around a rotating shaft 60 along the scale direction at a substantially central portion of the chassis 4 in the front-rear direction. The hammer 6 includes a mass portion 61 (mass body) for giving a feel of key depression when the white key 2a is depressed. The mass portion 61 is located on the rear side (right side in FIG. 1) with respect to the rotating shaft 60.

A portion of the hammer 6 on the front side of the rotating shaft 60 is configured as a pressing portion 62 for pressing the displacement member 7 when the white key 2a is depressed. A receiving portion 63 recessed downward is formed on the upper surface of the pressing portion 62, and the protrusion portion 21 of the white key 2a is inserted into the receiving portion 63.

The protrusion portion 21 protrudes downward from the lower surface of the substantially central portion of the white key 2a in the front-rear direction, and the bottom surface of the receiving portion 63 is configured as a slide surface on which the tip (lower end) of the protrusion portion 21 slides back and forth. When the white key 2a is depressed, the pressing portion 62 is pushed downward by the protrusion portion 21 while the protrusion portion 21 of the white key 2a slides along the bottom surface of the receiving portion 63, causing the hammer 6 to rotate around the rotating shaft 60 (counterclockwise in FIG. 1).

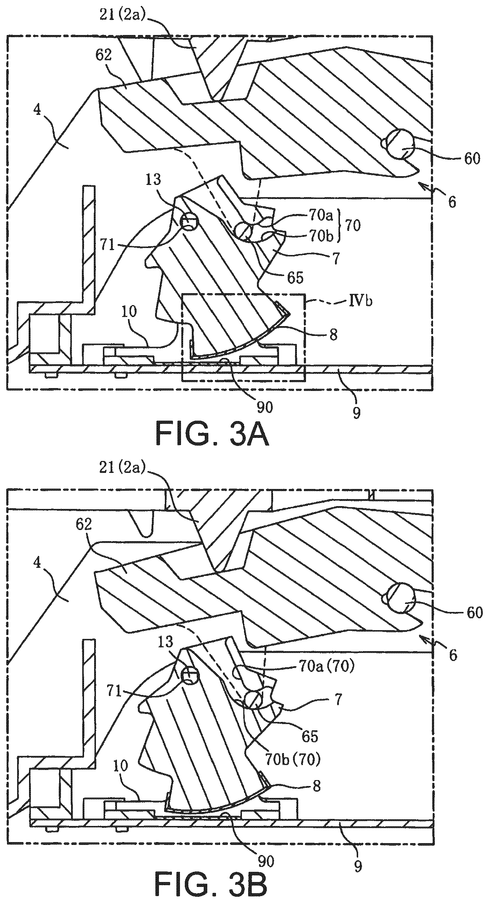

As the hammer 6 rotates, a guide pin 65 formed on the protrusion portion 64 of the hammer 6 slides along a groove 70 of the displacement member 7, thereby rotating the displacement member 7. Details of the structure for rotating the displacement member 7 will be described with reference to FIG. 2A, FIG. 2B, FIG. 3A, and FIG. 3B.

FIG. 2A is a partially enlarged cross-sectional view of the keyboard device 1 in the part IIa of FIG. 1, and FIG. 2B is a partially enlarged cross-sectional view of the keyboard device 1 along the line IIb-IIb in FIG. 2A. FIG. 3A is a partially enlarged cross-sectional view of the keyboard device 1 showing a state where the white key 2a is depressed from the state in FIG. 2A, and FIG. 3B is a partially enlarged cross-sectional view of the keyboard device 1 showing a state where the white key 2a is depressed to the terminal position from the state in FIG. 3A.

A detected portion (conductor) 8 is plated on the displacement member 7, and a coil 90 is printed on a substrate 9. FIG. 2A, FIG. 2B, FIG. 3A, and FIG. 3B schematically illustrate the cross sections of the detected portion 8 and the coil 90 (the same applies to subsequent figures).

As shown in FIG. 2A and FIG. 2B, the protrusion portion 64 protrudes downward from the lower surface of the pressing portion 62, and the guide pin 65 protrudes in the scale direction from a side surface of the protrusion portion 64 (surface facing the direction perpendicular to the paper surface of FIG. 2A). The protrusion portion 64 and the guide pin 65 are formed integrally with the pressing portion 62 of the hammer 6.

The guide pin 65 is slidably engaged with the groove 70 formed in the displacement member 7, and the displacement member 7 is rotatably supported by the holder 10 fixed to the substrate 9. The substrate 9 is fixed to the chassis 4 below the hammer 6, and the coil 90 for detecting the rotation of the displacement member 7 is printed on the substrate 9.

The holder 10 includes an attached portion 11 attached to the upper surface of the substrate 9, a wall portion 12 rising upward from the attached portion 11, and a substantially columnar shaft portion 13 formed on the upper end side of the wall portion 12. A plurality of wall portions 12 are arranged on the attached portion 11 that extends in the scale direction (left-right direction in FIG. 2B), and the displacement member 7 is rotatably supported between the wall portions 12 facing each other.

In the following description, among the side surfaces (surfaces facing the scale direction) of the wall portion 12, the side surface sandwiching the displacement member 7 is referred to as an inner side surface 12a of the wall portion 12 and the side surface opposite to the inner side surface 12a is referred to as an outer side surface 12b. The shaft portion 13 protrudes in the scale direction from the inner side surface 12a of the wall portion 12, and is inserted into an insertion hole 71 that penetrates through the displacement member 7 in the scale direction.

The displacement member 7 is rotated relative to the shaft portion 13 by sliding between the guide pin 65 of the hammer 6 and the groove 70 formed in the displacement member 7. The groove 70 extends rearward (toward the right side in FIG. 2A) from the upper end portion of the displacement member 7. The upper and lower surfaces of the groove 70, on which the guide pin 65 slides when the white key 2a is depressed (or released), are defined as an upper slide surface 70a and a lower slide surface 70b.

The guide pin 65 of the hammer 6 is engaged with the slide surfaces 70a and 70b of the groove 70 in a region between the rotating shaft 60 of the hammer 6 and the shaft portion 13 of the holder 10 (the rotating shaft of the displacement member 7). In the initial state before the white key 2a is depressed, the lower slide surface 70b of the groove 70 extends to intersect the displacement trajectory of the guide pin 65 around the rotating shaft 60.

Thus, as shown in FIG. 3A and FIG. 3B, when the pressing portion 62 of the hammer 6 is pushed downward by the protrusion portion 21 of the white key 2a during key depression and the guide pin 65 rotates around the rotating shaft 60 (counterclockwise in FIG. 3A and FIG. 3B), the lower slide surface 70b is pushed downward by the guide pin 65. As a result, the displacement member 7 rotates around the shaft portion 13 (clockwise in FIG. 3A and FIG. 3B).

As the displacement member 7 rotates, the detected portion 8 provided on the bottom surface of the displacement member 7 is displaced relative to the coil 90 of the substrate 9. That is, as the stroke amount of the white key 2a increases from the state before key depression, the amount of penetration of the detected portion 8 into the region (hereinafter referred to as "detection region") facing the coil 90 increases. The penetration amount of the detected portion 8 refers to the size of the area where the detected portion 8 and the coil 90 face each other in the thickness direction of the substrate 9.

On the other hand, when the white key 2a is depressed and then released (hereinafter referred to as "when the white key 2a is released"), the weight of the mass portion 61 (see FIG. 1) of the hammer 6 causes the guide pin 65 to rotate around the rotating shaft 60 (clockwise in FIG. 3A and FIG. 3B) so as to return to the initial state. Due to the rotation of the guide pin 65, the upper slide surface 70a is pushed up by the guide pin 65, thereby rotating the displacement member 7 around the shaft portion 13 (counterclockwise in FIG. 3A and FIG. 3B). At this time, the amount of penetration of the detected portion 8 into the detection region decreases.

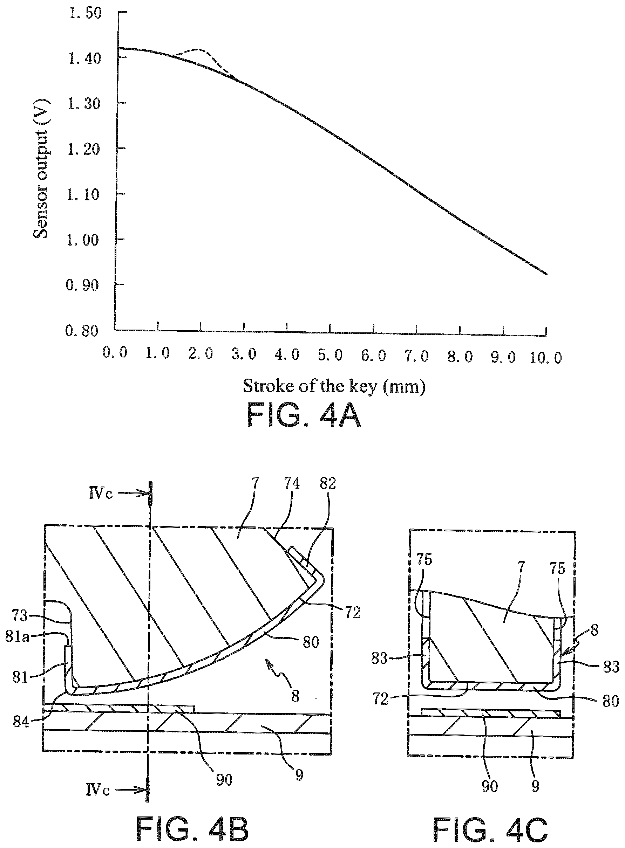

Since the detected portion 8 is formed using non-magnetic metal (such as copper), while a current flows through the coil 90 to generate a magnetic field, the inductance of the coil 90 decreases as the amount of penetration of the detected portion 8 into the detection region is increased, and the inductance of the coil 90 increases as the amount of penetration of the detected portion 8 into the detection region is reduced. A sensor output value (V) changes based on an increase or decrease in the inductance of the coil 90 (see FIG. 4A). Key depression information (note information) is detected based on an increase or decrease in the sensor output value.

The sensor output will be described with reference to FIG. 3A, FIG. 3B, FIG. 4A, FIG. 4B, and FIG. 4C. FIG. 4A is a graph showing the relationship between the stroke amount of the key 2 and the sensor output, wherein the vertical axis indicates the magnitude (V) of the sensor output and the horizontal axis indicates the stroke amount (mm) of the key 2. FIG. 4B is a partially enlarged cross-sectional view of the keyboard device 1 in which the part IVb in FIG. 3A is enlarged, and FIG. 4C is a partially enlarged cross-sectional view of the keyboard device 1 along the line IVc-IVc in FIG. 4B. FIG. 4B and FIG. 4C omit illustration of a part of the configuration (such as the holder 10 shown in FIG. 3A and FIG. 3B), and only show main parts of the keyboard device 1.

As shown in FIG. 4A, in this embodiment, the sensor output decreases substantially proportionally as the white key 2a is depressed. This is because the lower slide surface 70b of the groove 70 is formed in an arc shape that is convex downward, as shown in FIG. 3A and FIG. 3B, and the stroke amount of the white key 2a when depressed (the rotation amount of the guide pin 65 around the rotating shaft 60) and the rotation amount of the displacement member 7 around the shaft portion 13 are substantially proportional.

In addition, since the upper slide surface 70a also has a shape corresponding to the lower slide surface 70b (the interval between the slide surfaces 70a and 70b is constant), when the white key 2a is released, the sensor output increases substantially in proportion to the amount of decrease in the stroke of the white key 2a. Key depression information such as the depth and speed of the depression of the white key 2a is detected based on the increase or decrease in the sensor output. In order to accurately detect the key depression information, it is necessary to set the clearance between the detected portion 8 and the coil 90 to dimensions according to designed values for each key 2.

In the conventional technique that detects key depression information with such a contactless sensor, the detected portion is provided on a rotating member such as the key 2 or the hammer 6 (for example, Japanese Patent Application Laid-Open No. 03-048295). In the case of such a configuration, the clearance between the coil 90 and the detected portion 8 is likely to vary for each key.

The first reason for this variation is that the key 2 or the hammer 6 itself is large in size (long in the front-rear direction) so the key 2 or the hammer 6 tends to have dimensional errors. The second reason is that the chassis 4 that supports the key 2 and the hammer 6 is also large in size so errors in attaching (assembling) the key 2 and the hammer 6 are likely to occur.

In contrast thereto, in this embodiment, as shown in FIG. 3A and FIG. 3B, the detected portion 8 is provided on the displacement member 7 interlocking with the white key 2a and the hammer 6, not on the white key 2a and the hammer 6. Because the displacement member 7 can be formed smaller than the white key 2a and the hammer 6, each displacement member 7 is less likely to have dimensional errors. Besides, because the displacement member 7 is axially supported by the relatively small holder 10 directly attached to the substrate 9 instead of the chassis 4, errors in attaching each displacement member 7 are less likely to occur. By reducing these dimensional errors and attaching errors, the clearance between the coil 90 and the detected portion 8 is easily set to dimensions according to the designed values for each key 2, which enables the key depression information of each key 2 to be detected with high accuracy.

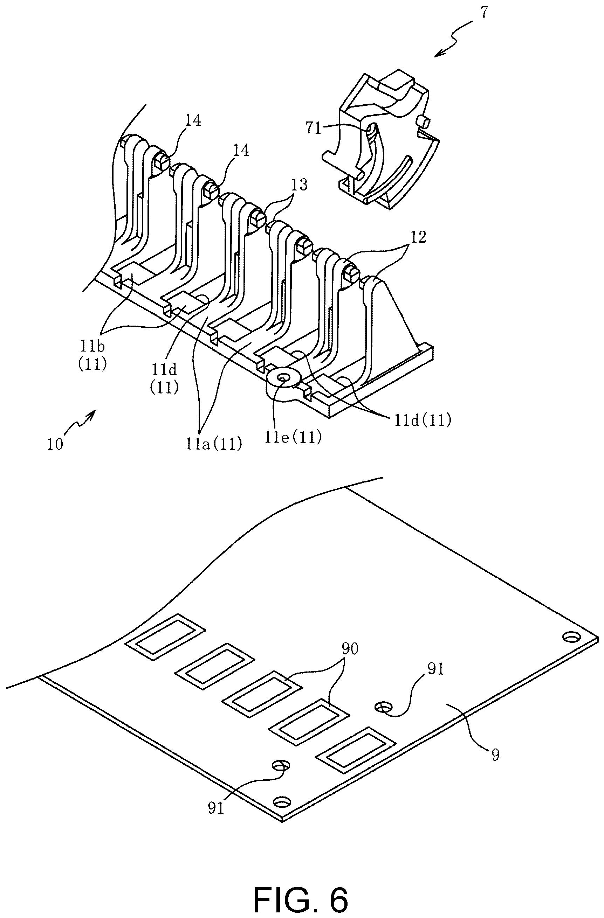

Further, although details will be described later, a plurality of displacement members 7 arranged in the scale direction are supported by one holder 10 (see FIG. 6). Therefore, compared to a case where a separate holder 10 is provided for each of the plurality of displacement members 7 (one displacement member 7 is attached to the substrate 9 with one holder 10), for example, the clearance between the coil 90 and the detected portion 8 is easily set to dimensions according to the designed values for each key 2.

Furthermore, fixing the holder 10 extending in the scale direction to the substrate 9 allows the holder 10 to restrict deformation of the substrate 9, which also makes it easy to set the clearance between the coil 90 and the detected portion 8 to dimensions according to the designed values for each key 2.

In addition, if the configuration allows the guide pin 65 of the hammer 6 and the groove 70 of the displacement member 7 to be engaged, that is, the configuration allows the displacement member 7 to rotate in conjunction with the hammer 6, the shape of the displacement member 7 and the arrangement of the rotating shaft (shaft portion 13) can be changed freely. That is, by appropriately setting the shape of the displacement member 7 and the position of the rotating shaft, the arrangement of the coil 90 (the arrangement of the coil 90 on the substrate 9 and the arrangement of the substrate 9 itself) can also be changed to a desired position. Thus, the flexibility in designing the keyboard device 1 is improved.

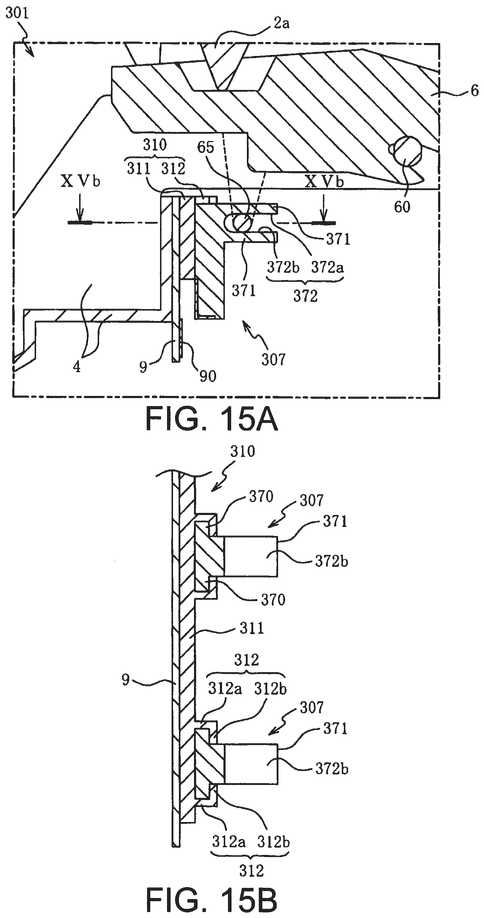

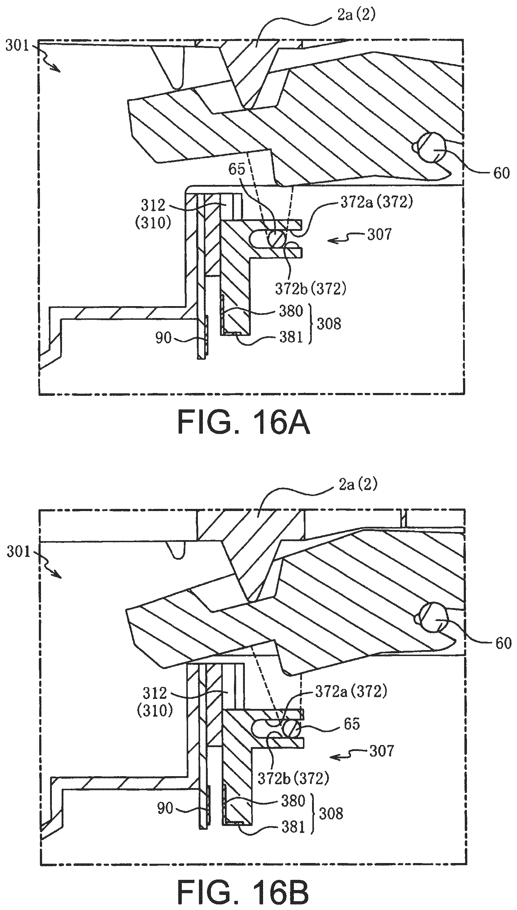

Here, a configuration in which the displacement member 307 is slidably supported by the holder 310 fixed to the substrate 9, as in the third embodiment (see FIG. 15A, FIG. 15B, FIG. 16A, and FIG. 16B) described later, is also capable of reducing dimensional errors and attaching errors of the displacement member 307. However, in the case of the configuration of the third embodiment, the displacement member 307 may not slide smoothly with respect to the holder 310, and the feel of depressing the white key 2a tends to deteriorate.

In contrast thereto, in this embodiment, the displacement member 7 is rotatably supported by the holder 10, which allows the displacement member 7 to be smoothly interlocked with the rotation of the hammer 6 and therefore suppresses deterioration of the feel when depressing the white key 2a.

As shown in FIG. 4B, the bottom surface 72 (opposing surface facing the coil 90) of the displacement member 7 is formed in an arc shape centering on the insertion hole 71 (see FIG. 3A and FIG. 3B). A front surface 73 and a rear surface 74 of the displacement member 7 are connected to both the front and rear ends of the bottom surface 72 of the displacement member 7. The front surface 73 of the displacement member 7 is directed to the front side (left side in FIG. 4B) in the rotation direction of the displacement member 7 and the rear surface 74 of the displacement member 7 is directed to the rear side (right side in FIG. 4B) in the same direction. The front surface 73 of the displacement member 7 is a flat surface extending from the front edge of the bottom surface 72 in the normal direction of the bottom surface 72, and the rear surface 74 is a flat surface extending from the rear edge of the bottom surface 72 in the normal direction of the bottom surface 72.

In order to change the magnetic field of the coil 90, the detected portion 8 may be provided only on the bottom surface 72 of the displacement member 7, but the detected portion 8 of this embodiment includes a facing portion 80 that covers the entire bottom surface 72 of the displacement member 7 (facing the coil 90), and a front surface portion 81 that is connected to the front end of the facing portion 80 and covers the front surface 73 of the displacement member 7. This is because when the detected portion 8 is formed only on the bottom surface 72 of the displacement member 7, there arises a problem that the output value of the sensor temporarily rises (hereinafter referred to as "overshoot of sensor output") at the initial stage of depressing the white key 2a (when the stroke amount is about 2 mm), as indicated by the broken line in FIG. 4A.

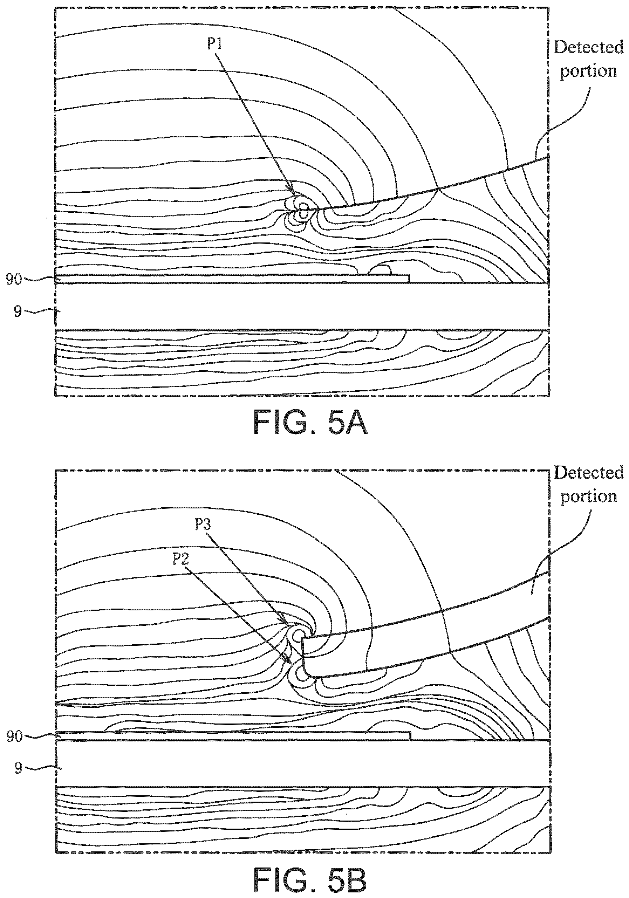

The overshoot of sensor output will be described with reference to FIG. 5A and FIG. 5B. FIG. 5A is a schematic diagram of the magnetic field (lines of magnetic force) when a thin detected portion is formed only on the bottom surface 72 of the displacement member 7, and FIG. 5B is a schematic diagram of the magnetic field (lines of magnetic force) when the detected portion 8 (the facing portion 80 and the front surface portion 81) is formed on the bottom surface 72 and the front surface 73 of the displacement member 7. FIG. 5A and FIG. 5B schematically show the state of the magnetic field analyzed by simulation software.

As shown in FIG. 5A, in the case where the detected portion 8 is formed thin (the detected portion 8 is provided only on the bottom surface 72 of the displacement member 7), when the detected portion 8 starts to enter the detection region (position facing the coil 90 of the substrate 9), the lines of magnetic force (magnetic flux) are concentrated at one point on the front edge portion P1 of the detected portion 8. The concentration of the lines of magnetic force at one point is considered to cause an overshoot of sensor output.

On the other hand, as shown in FIG. 5B, in the case where the detected portion 8 is provided with the front surface portion 81, when the detected portion 8 starts to enter the detection region, the concentration of the lines of magnetic force (magnetic flux) is dispersed at the connection portion P2 between the facing portion 80 and the front surface portion 81 of the detected portion 8 and the upper edge portion P3 of the front surface portion 81. More specifically, a portion (P3) of the point where the lines of magnetic force are concentrated is separated from the region that is close to the coil and has a strong magnetic field, thereby mitigating the effect on a change in the magnetic field. It is considered that dispersing the concentration of the lines of magnetic force in this way achieves sensor output without overshoot as indicated by the solid line in FIG. 4A. By suppressing the overshoot of sensor output, the key depression information can be detected with high accuracy.

In this case, it is considered that even if the detected portion 8 is formed using a thick metal plate as in the conventional technique (for example, the metal plate 55 shown in FIG. 29 of Japanese Patent Application Laid-Open No. 03-048295), the front surface of the detected portion 8 can have a relatively large vertical width so an overshoot of sensor output as described above can be suppressed. However, using a thick metal plate leads to an increase in the weight and cost of the keyboard device 1.

In contrast thereto, in this embodiment, as shown in FIG. 4B, the front surface 73 of the displacement member 7 is covered with the front surface portion 81 that rises (bends) from the facing portion 80 of the detected portion 8. Such a configuration can ensure a large vertical width of the front surface portion 81 even if the thickness of the detected portion 8 is reduced. That is, an overshoot of sensor output can be suppressed without using a thick metal plate as in the conventional technique, so the key depression information can be accurately detected while suppressing an increase in the weight and cost of the keyboard device 1.

Further, in this embodiment, in addition to the front surface 73 of the displacement member 7, the rear surface 74 of the displacement member 7 is also provided with the rear surface portion 82 of the detected portion 8. The rear surface portion 82 is connected to the rear end of the facing portion 80 of the detected portion 8 and covers the rear surface 74 of the displacement member 7. Further, as shown in FIG. 4C, a pair of side surface portions 83 of the detected portion 8 are provided on the side surfaces 75 of the displacement member 7. The side surface portions 83 rise upward from both ends of the facing portion 80 in the scale direction (left-right direction in FIG. 4C).

The reason to form the rear surface portion 82 and the side surface portions 83 in addition to the facing portion 80 and the front surface portion 81 of the detected portion 8 is to easily form the detected portion 8 on the displacement member 7 by plating. That is, when forming the detected portion 8 on the displacement member 7 by plating, the displacement member 7 is masked in a way to expose the region for forming the detected portion 8. By applying metal plating to the masked displacement member 7, the detected portion 8 is not formed in the region where the masking is present (no plating adheres), and the detected portion 8 is formed on the outer surface of the displacement member 7 exposed from the masking.

When forming the detected portion 8 by such plating, for example, for a configuration in which the detected portion 8 (the facing portion 80 and the front surface portion 81) is provided only on the bottom surface 72 and the front surface 73 of the displacement member 7, it is necessary to mask the front surface 73 and the side surfaces 75 of the displacement member 7 with a step. For this reason, the work of masking the displacement member 7 takes time and effort.

In contrast thereto, in this embodiment, the portions 80 to 83 of the detected portion 8 are respectively formed on the bottom surface 72, the front surface 73, the rear surface 74, and the side surfaces 75 of the displacement member 7, masking with a step as described above is not required. Thus, this embodiment is capable of facilitating the masking for the displacement member 7.

Since the detected portion 8 of this embodiment is formed by plating the outer surface of the displacement member 7 with metal as described above, the thicknesses of the portions 80 to 83 of the detected portion 8 are substantially constant. The "thicknesses are substantially constant" means that the minimum and maximum thicknesses of the front surface portion 81, for example, are within a range of ±30% of the average value of the thicknesses of the portions 80 to 83 of the detected portion 8.

Besides, the vertical width dimensions (rising height from the facing portion 80) of the front surface portion 81, the rear surface portion 82, and the pair of side surface portions 83 of the detected portion 8 are substantially constant as well. The "vertical width dimensions are substantially constant" means that the minimum and maximum vertical width dimensions of the front surface portion 81, for example, are within a range of ±30% of the average value of the vertical width dimensions of the portions 80 to 83 of the detected portion 8.

In this way, the vertical width dimension (rising height from the facing portion 80) of the front surface portion 81 of the detected portion 8 is substantially constant, and the upper edge 81a of the front surface portion 81 of the detected portion 8 is formed in a straight line shape along the scale direction (direction perpendicular to the paper surface in FIG. 4B). Thus, compared to a case where the upper edge 81a of the front surface portion 81 has a sharp portion (for example, the upper edge 81a of the front surface portion 81 is chevron-shaped), a change in the magnetic field can be suppressed from concentrating on a part of the upper edge 81a of the front surface portion 81, which allows the key depression information to be detected with high accuracy.

Further, the detected portion 8 includes a curved portion 84 that curves and connects the facing portion 80 and the front surface portion 81. Since the curved portion 84 smoothly connects the boundary (corner) portion between the front end of the facing portion 80 and the lower end of the front surface portion 81, a change in the magnetic field can be suppressed from concentrating at the boundary portion, which allows the key depression information to be detected with high accuracy.

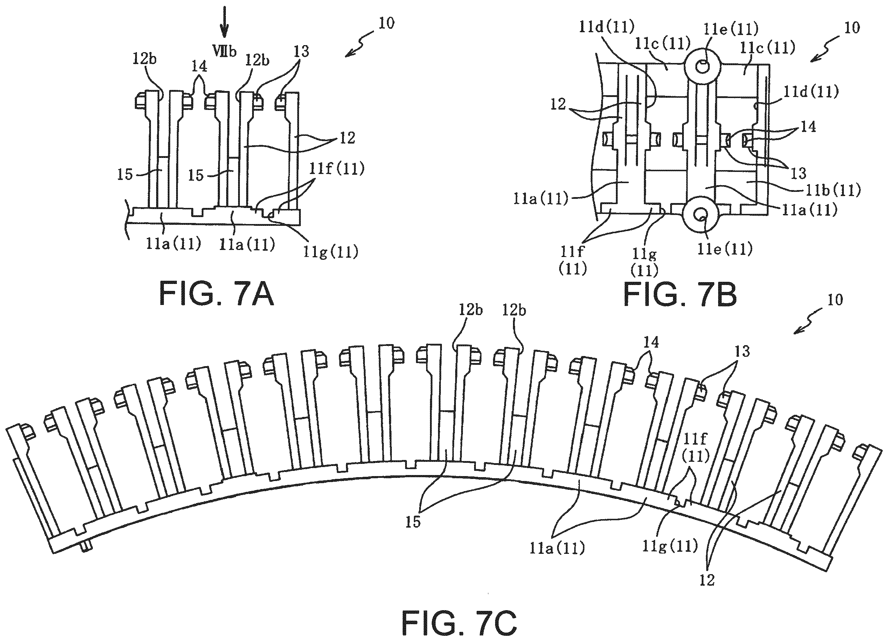

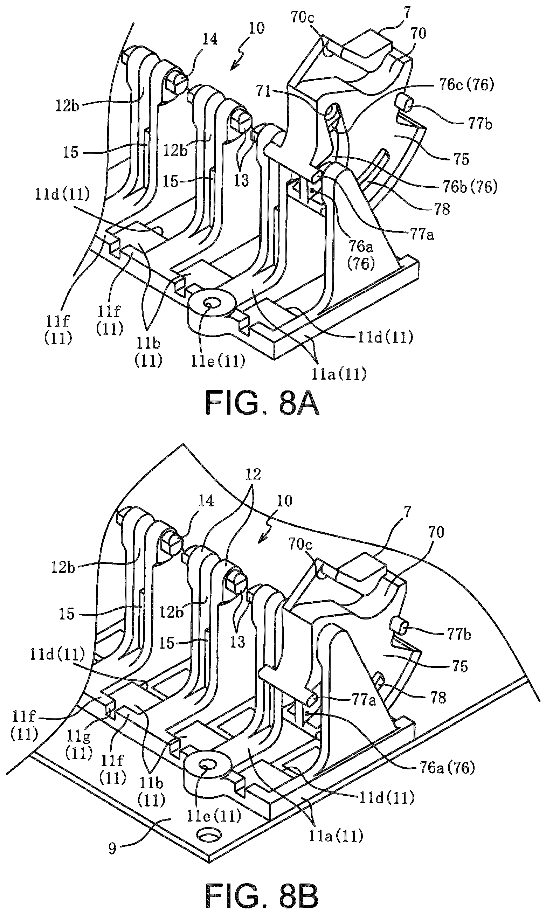

Next, a method of attaching the displacement member 7 to the substrate 9 (holder 10) will be described with reference to FIG. 6 to FIG. 8A and FIG. 8B. FIG. 6 is an exploded perspective view of the keyboard device 1. FIG. 7A is a partially enlarged front view of the holder 10, FIG. 7B is a partially enlarged top view of the holder 10 viewed in the direction of the arrow VIIb in FIG. 7A, and FIG. 7C is a front view of the holder 10 showing a state where the holder 10 is bent. FIG. 8A is a perspective view showing how the shaft portion 13 of the holder 10 is slid along the guide groove 76, FIG. 8B is a perspective view showing a state where the holder 10 with the displacement member 7 attached thereto is fixed to the substrate 9.

As shown in FIG. 6, a plurality of coils 90 are arranged in the scale direction on the substrate 9, and a plurality of displacement members 7 are axially supported by the holder 10 above these coils 90. The displacement member 7 and the holder 10 are attached to the substrate 9 by attaching the displacement member 7 to the holder 10 and then fixing the holder 10 to the substrate 9.

As shown in FIG. 6 and FIG. 7A to FIG. 7C, the attached portion 11 of the holder 10 fixed to the upper surface of the substrate 9 includes a base portion 11a from which the wall portion 12 rises, and connecting portions 11b and 11c (see FIG. 7B for the connecting portion 11c) connecting the base portions 11a to each other. These portions 11a to 11c are integrally formed using a resin material (synthetic resin).

The base portion 11a extends from the lower end of the wall portion 12 to both front and rear sides, and both front and rear end portions of the base portion 11a are connected in the scale direction by the connecting portions 11b and 11c. Accordingly, the attached portion 11 is formed with a rectangular through hole 11d surrounded by the base portion 11a and the connecting portions 11b and 11c. The through holes 11d are arranged in the scale direction at intervals corresponding to the coils 90 of the substrate 9.

A plurality of screw holes 11e are formed in the attached portion 11, and the holder 10 is fixed to the substrate 9 by screwing screws (not shown) inserted into the through holes 91 of the substrate 9 into the screw holes 11e of the attached portion 11.

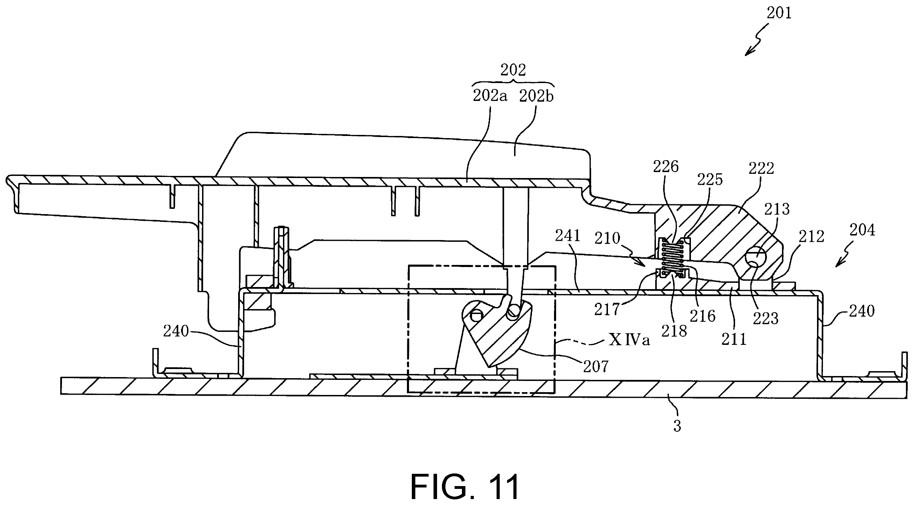

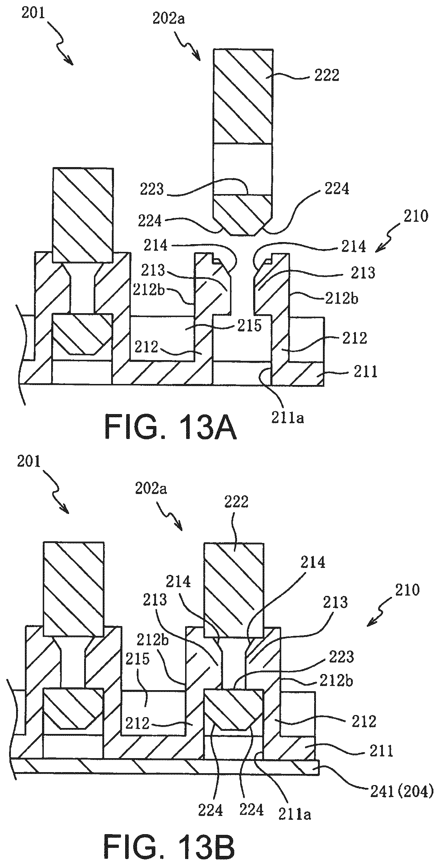

Since a plurality of displacement members 7 arranged in the scale direction are attached to the holder 10, the configuration of this embodiment is capable of preventing the displacement member 7 from coming off after attachment while facilitating the attachment. This configuration will be described below. The issue of "preventing coming off while facilitating the attachment of the rotating members" also occurs to the key 2 and the hammer 6, and a support structure for the key 202 that solves this issue will be described later in the second embodiment (FIG. 11 to FIG. 13A and FIG. 13B).

In the holder 10 of this embodiment, the base portions 11a of the attached portion 11 are connected to each other by the flat plate-shaped connecting portions 11b and 11c. Thus, in a state before the holder 10 is fixed to the substrate 9, the attached portion 11 (connecting portions 11b and 11c) can be bent as shown in FIG. 7C. By bending the attached portion 11, the interval between the shaft portions 13 formed on the wall portions 12 is slightly widened, which allows a pair of shaft portions 13 to be easily inserted into the insertion hole 71 of the displacement member 7, as shown in FIG. 8A, when attaching the displacement member 7 to the holder 10. Thus, the workability of attaching the displacement member 7 can be improved.

On the other hand, after attaching the displacement member 7 to the holder 10, the holder 10 is fixed to the substrate 9 that has relatively higher rigidity (than the holder 10), as shown in FIG. 8B, which suppresses the interval between the shaft portions 13 of the wall portions 12 from widening (suppresses the attached portion 11 from bending). Since the shaft portions 13 are prevented from coming off from the insertion hole 71 of the displacement member 7, the displacement member 7 can be prevented from coming off from the holder 10.

As shown in FIG. 7A to FIG. 7C, FIG. 8A, and FIG. 8B, the thicknesses of the connecting portions 11b and 11c connecting the base portions 11a are smaller than the thickness of the base portion 11a from which the wall portion 12 rises. By forming such a thin portion between the base portions 11a, the attached portion 11 is easily bent to widen the interval between the wall portions 12 (shaft portions 13) facing each other.

Furthermore, since the through hole 11d is formed between the connecting portions 11b and 11c (between the wall portions 12), the attached portion 11 is also easily bent. The pair of shaft portions 13 can be easily inserted into the insertion hole 71 of the displacement member 7 by forming the attached portion 11 to be easily bent.

Here, the periphery of the screw hole 11e of the attached portion 11 needs to be formed relatively thick for the axial force of the screw acting thereon. Therefore, if the screw hole 11e is formed on the front side or the rear side (regions where the connecting portions 11b and 11 c are formed) between the wall portions 12, for example, the deformation of the attached portion 11 that widens the interval between the wall portions 12 (shaft portions 13) is likely to be hindered.

In contrast thereto, in this embodiment, the screw holes 11e are formed on both front and rear ends of the base portion 11a, so the thicknesses on the front side and the rear side (regions where the connecting portions 11b and 11c are formed) between the wall portions 12 can be reduced. As a result, the attached portion 11 is easily bent to widen the interval between the wall portions 12 (shaft portions 13) facing each other, so the pair of shaft portions 13 can be easily inserted into the insertion hole 71 of the displacement member 7.

The insertion of the shaft portion 13 into the insertion hole 71 is guided by the guide groove 76 formed in each of the pair of side surfaces 75 of the displacement member 7 (see FIG. 8A). The guide groove 76 bends forward while extending downward from the insertion hole 71, and an open portion 76a of the guide groove 76 is formed at the front end of the displacement member 7. The thickness of the displacement member 7 in the scale direction in the region where the open portion 76a is formed is formed to be smaller than the interval between the pair of shaft portions 13 facing each other. That is to say, each guide groove 76 formed in the pair of side surfaces 75 of the displacement member 7 is configured to be able to receive the pair of shaft portions 13 from the open portion 76a.

As described above, the guide groove 76 is connected to the insertion hole 71 on one end side, and is configured to be able to receive the shaft portion 13 from the open portion 76a on the other end side. Thus, by sliding the shaft portion 13 received from the open portion 76a along the guide groove 76, the shaft portion 13 can be guided toward the insertion hole 71, which allows the pair of shaft portions 13 to be easily inserted into the insertion hole 71 of the displacement member 7.

Here, the surface of the guide groove 76 that faces the scale direction (opposes the tip of the shaft portion 13) is defined as a groove bottom surface 76b. The groove bottom surface 76b is formed with an inclined surface 76c that is inclined upward toward the insertion hole 71 to increase the thickness of the displacement member 7 in the scale direction. When the shaft portion 13 slides on the inclined surface 76c, the elastic deformation of the wall portions 12 automatically increases the interval between the pair of shaft portions 13 facing each other. Since it is not necessary for the operator to widen the interval between the shaft portions 13 facing each other with fingers, the pair of shaft portions 13 can be easily inserted into the insertion hole 71 of the displacement member 7.

In this embodiment, the inclined surface 76c is formed in the vicinity of the insertion hole 71. However, an inclination corresponding to the inclined surface 76c may be provided in the vicinity of the open portion 76a, for example. That is, the position at which the inclined surface 76c is formed in the groove 70 may be appropriately set. The vicinity of the insertion hole 71 refers to a position where the distance from the inclined surface 76c to the insertion hole 71 is closer than the distance from the open portion 76a to the inclined surface 76c.

When the shaft portion 13 slides on the inclined surface 76c of the guide groove 76, the inclined surface 14 formed on the shaft portion 13 slides on the inclined surface 76c. The inclined surface 14 is inclined upward so that the upper end of the tip surface of the shaft portion 13 is obliquely cut (away from the opposing shaft portion 13). That is, because the inclined surface 14 is inclined in a direction corresponding to the inclined surface 76c of the guide groove 76, the inclined surfaces 14 and 76c slide against each other when the shaft portion 13 slides along the inclined surface 76c. Thus, the shaft portion 13 can be slid smoothly with respect to the inclined surface 76c, for example, compared to a case where the shaft portion 13 is not formed with the inclined surface 14. Therefore, the pair of shaft portions 13 can be easily inserted into the insertion hole 71 of the displacement member 7.

The attachment of the displacement member 7 to the holder 10 is completed by inserting the pair of shaft portions 13 into the insertion hole 71. After attaching the displacement member 7, the detachment of the displacement member 7 due to elastic deformation of the holder 10 (the attached portion 11 and the wall portion 12) can be generally suppressed by the fixing of the holder 10 to the substrate 9 as described above.

Although the substrate 9 has relatively high rigidity (compared to the holder 10), deformation may still occur. In order to more reliably prevent the displacement member 7 from coming off, the holder 10 also needs to have a certain degree of rigidity.

Therefore, in this embodiment, the holder 10 is formed with the connection portion 15 that connects the outer side surfaces 12b of the wall portions 12 to each other. Such a connection portion 15 is capable of restricting the widening of the interval between the wall portions 12 facing each other after the holder 10 is attached to the substrate 9, thereby preventing the displacement member 7 from coming off from the holder 10.

However, if the entire outer side surface 12b of the wall portion 12 (from the upper end to the lower end) is connected by the connection portion 15, for example, it is difficult for the wall portion 12 to elastically deform when the shaft portion 13 slides on the inclined surface 76c of the guide groove 76. Therefore, in this embodiment, only the region on the lower end side of the outer side surface 12b of the wall portion 12 is connected by the connection portion 15. That is, the connection portion 15 connects the outer side surfaces 12b of the wall portions 12 below the shaft portion 13 (on the side of the attached portion 11), and a gap is formed between the outer side surfaces 12b in the region where the shaft portion 13 is formed (at the position overlapping the shaft portion 13 in the scale direction).

Since this gap allows the wall portion 12 to elastically deform when the shaft portion 13 slides on the inclined surface 76c of the guide groove 76, the pair of shaft portions 13 can be easily inserted into the insertion hole 71 of the displacement member 7. As partial regions of the outer side surfaces 12b of the wall portions 12 are connected by the connection portion 15 in the vertical direction (the rising direction of the wall portion 12 from the base portion 11a) in this way, the wall portions 12 are allowed to elastically deform appropriately. Therefore, this embodiment is capable of preventing the displacement member 7 from coming off from the holder 10 after attachment while facilitating the attachment of the displacement member 7 to the holder 10.

Furthermore, in order to give the holder 10 a certain degree of rigidity, in this embodiment, a thick portion 11f is formed in the connecting portion 11b, which connects the front ends of the base portions 11a, among the connecting portions 11b and 11c. The thick portion 11f is a portion formed with the same thickness as the base portion 11a. The thick portion 11f extends in the scale direction from the front end portion of the base portion 11a, and a cutout portion 11g is formed in the central portion of the thick portion 11f in the scale direction.

Providing the thick portion 11f and the cutout portion 11g allows the attached portion 11 (connecting portions 11b and 11c) to be elastically deformed appropriately. That is, this embodiment is capable of suppressing the elastic deformation of the attached portion 11 after being fixed to the substrate 9 while allowing the attached portion 11 to bend (see FIG. 7C). Therefore, this embodiment is capable of preventing the displacement member 7 from coming off from the holder 10 after attachment while facilitating the attachment of the displacement member 7 to the holder 10.

After fixing the holder 10 with the displacement member 7 attached thereto to the substrate 9, assembly work such as inserting the guide pin 65 (see FIG. 3A and FIG. 3B) of the hammer 6 from the open portion 70c (see FIG. 8A and FIG. 8B) of the groove 70 formed above the wall portion 12 is performed. The workability deteriorates if the displacement member 7 rotates excessively with respect to the holder 10 during such assembly work. Therefore, the displacement member 7 has protrusions 77a and 77b for restricting the rotation.

The protrusions 77a and 77b are protrusions that protrude in the scale direction from the side surfaces 75 of the displacement member 7. In the state where the displacement member 7 is attached to the holder 10, the protrusion 77a is located on the front side of the wall portion 12 (the front side in the rotation direction of the displacement member 7), and the protrusion 77b is located on the rear side of the wall portion 12. As a result, excessive rotation of the displacement member 7 with respect to the holder 10 can be restricted by the contact between the protrusions 77a and 77b and the wall portions 12. Thus, the workability of the assembly work as described above can be improved.

In this embodiment, the protrusions 77a and 77b are respectively formed on the pair of side surfaces 75 of the displacement member 7, but the protrusions 77a and 77b may be formed on only one of the pair of side surfaces 75.

Further, the displacement member 7 is formed with a guide portion 78 for stabilizing the rotation of the displacement member 7 with respect to the holder 10. The guide portion 78 is a convex portion that protrudes in the scale direction from each of the pair of side surfaces 75 of the displacement member 7. By providing such a guide portion 78, the rotation of the displacement member 7 around the shaft portion 13 can be guided by the contact between the guide portion 78 and the wall portion 12. Since the detected portion 8 can be easily rotated while maintaining a predetermined clearance with respect to the coil 90 of the substrate 9, the key depression information can be detected with high accuracy.

Since the guide portion 78 extends in an arc shape centering on the insertion hole 71 (the shaft portion 13 that is the rotating shaft of the displacement member 7), the rotation of the displacement member 7 can be guided by the guide portion 78 and the contact area of the guide portion 78 for the wall portion 12 can be reduced. Thus, the guide portion 78 slides smoothly on the wall portion 12 easily.

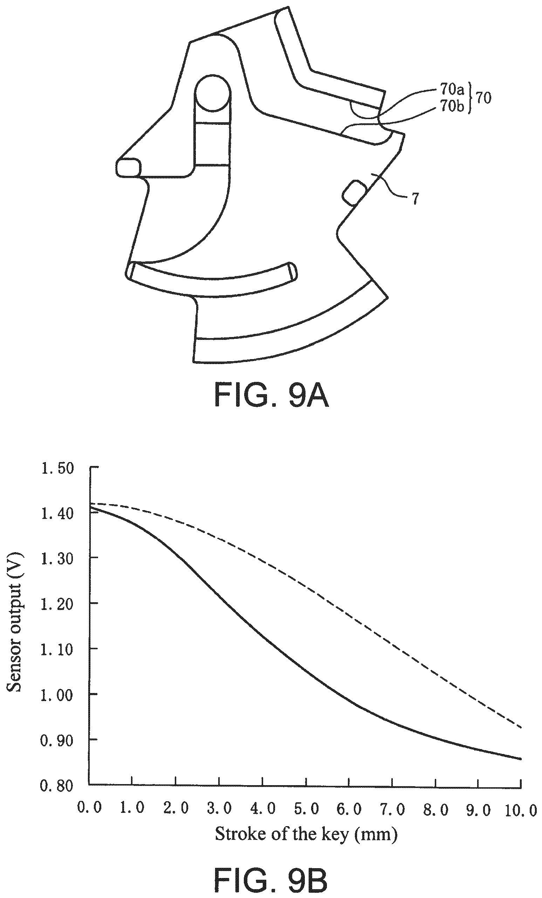

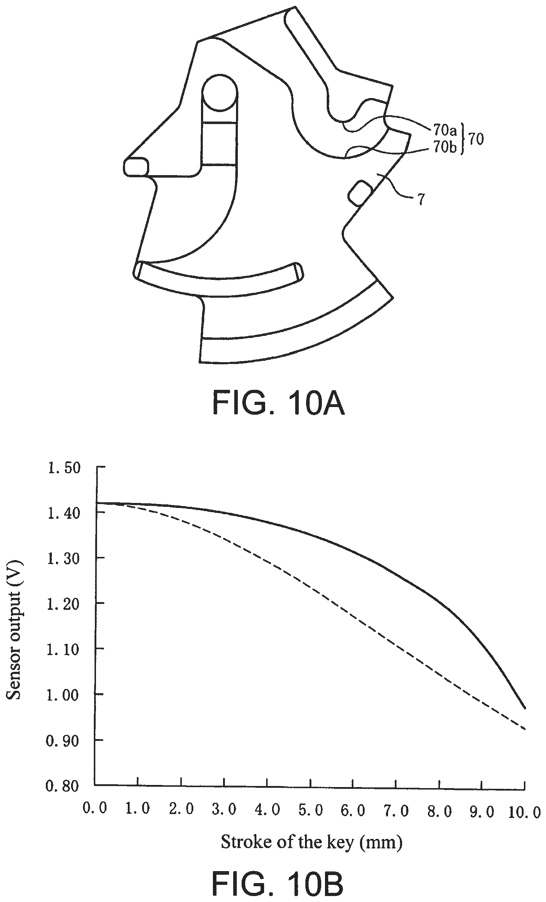

Next, modified examples of the displacement member 7 will be described with reference to FIG. 9A, FIG. 9B, FIG. 10A, and FIG. 10B. The first embodiment described above illustrates a case where the sensor output decreases substantially in proportion to the stroke amount of the key 2 during key depression.

In contrast thereto, the modified examples of FIG. 9A, FIG. 9B, FIG. 10A, and FIG. 10B illustrate a configuration for increasing the degree of decrease in the sensor output with respect to the stroke amount of the key 2 during key depression and a configuration for moderating the decrease in the sensor output, compared to the first embodiment.

FIG. 9A is a side view of the displacement member 7 showing the first modified example, and FIG. 9B is a graph showing the relationship between the stroke amount of key depression and the sensor output when the displacement member 7 of the first modified example is used. FIG. 10A is a side view of the displacement member 7 showing the second modified example, and FIG. 10B is a graph showing the relationship between the stroke amount of key depression and the sensor output when the displacement member 7 of the second modified example is used. In FIG. 9B and FIG. 10B, the broken line indicates the sensor output when the displacement member 7 of the first embodiment above is used.

The displacement members 7 in the modified examples of FIG. 9A and FIG. 10A have the same configuration as the displacement member 7 of the first embodiment, except that the grooves 70 (the upper slide surface 70a and the lower slide surface 70b) have different shapes. The modified examples of FIG. 9A and FIG. 10A will be described with the same reference numerals as the first embodiment.

As shown in FIG. 9A, the groove 70 of the displacement member 7 in the first modified example has an upper slide surface 70a and a lower slide surface 70b formed in a straight line shape. That is, in the first modified example, the radii of curvature of the slide surfaces 70a and 70b are increased as compared to the first embodiment. By forming the groove 70 in such a shape, the rotation amount of the displacement member 7 with respect to the stroke amount of the key 2 (that is, the rotation amount of the guide pin 65 around the rotating shaft 60 shown in FIG. 3A and FIG. 3B) is greater than that in the first embodiment. Thus, according to the displacement member 7 of the first modified example, as shown in FIG. 9B, the degree of decrease in the sensor output with respect to the stroke amount of the key 2 during key depression can be made greater than that in the first embodiment.

As shown in FIG. 10A, the radii of curvature of the upper slide surface 70a and the lower slide surface 70b of the groove 70 of the displacement member 7 in the second modified example are decreased as compared to the first embodiment. By forming the groove 70 in such a shape, the rotation amount of the displacement member 7 with respect to the stroke amount of the key 2 is smaller than that in the first embodiment. Thus, according to the displacement member 7 of the second modified example, as shown in FIG. 10B, the degree of decrease in the sensor output with respect to the stroke amount of the key 2 during key depression can be made gentler than that in the first embodiment.

Thus, in the first embodiment and the modified examples shown in FIG. 9A and FIG. 10A, the displacement member 7 is rotated by the sliding between the guide pin 65 (see FIG. 3A and FIG. 3B) of the hammer 6 and the groove 70, so the sensor output (that is, the displacement mode of the displacement member 7) can be adjusted by changing the shape of the groove 70. In other words, the sensor output according to the user's request can be obtained by attaching the displacement member 7 according to the sensor output requested by the user to the keyboard device 1 or replacing the displacement member 7 attached to the keyboard device 1.

It is also possible to adopt a configuration in which the groove 70 is formed on the side of the hammer 6 and the guide pin 65 is formed on the side of the displacement member 7, for example, when adjusting the sensor output. However, the hammer 6 itself is large in size and expensive. Therefore, if the groove 70 is formed on the side of the hammer 6, the cost increases for replacing the hammer 6 with a different shape of groove 70 (changing the sensor output).

On the other hand, the displacement member 7 can be made smaller (lower cost) than the hammer 6. Thus, the cost for replacing the displacement member 7 with a different shape of groove 70 (changing the sensor output) can be reduced by forming the groove 70 on the side of the displacement member 7 and forming the guide pin 65 on the side of the hammer 6.

Although it is illustrated that the upper slide surface 70a and the lower slide surface 70b of the groove 70 in the displacement member 7 shown in the first embodiment and FIG. 9A and FIG. 10A have corresponding shapes (the interval between the slide surfaces 70a and 70b is constant), that is, the correlation between the stroke amount of the key 2 and the sensor output is the same when the key is depressed and when the key is released, the present invention is not necessarily limited thereto.

For example, the shape of the upper slide surface 70a (see FIG. 3A and FIG. 3B) of the first embodiment may be changed to the shape of the upper slide surface 70a (see FIG. 9A) of the first modified example. That is, the interval between the slide surfaces 70a and 70b in a part (or all) of the region where the guide pin 65 slides may be changed so that the correlation between the stroke amount of the key 2 and the sensor output is different between when the key is depressed and when the key is released.

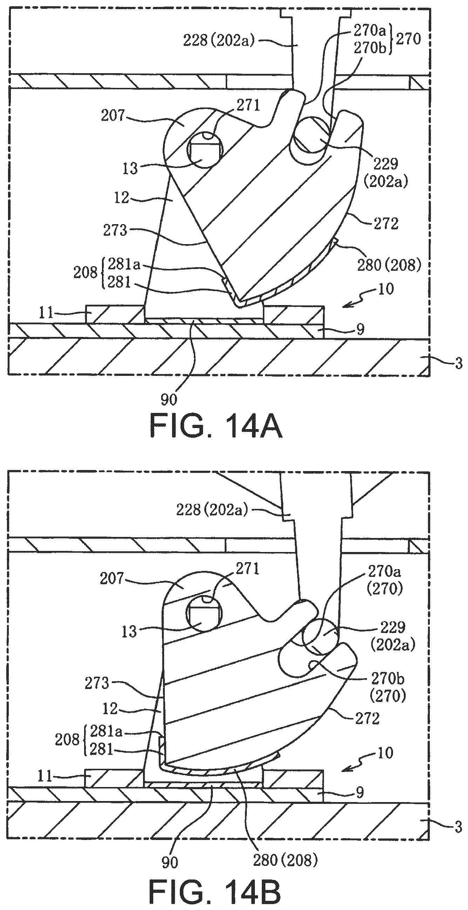

Next, a keyboard device 201 of the second embodiment will be described with reference to FIG. 11 to FIG. 14A and FIG. 14B. The first embodiment described above illustrates a case where the displacement member 7 is rotatably supported by the holder 10 and a case where the displacement member 7 is rotated by the hammer 6. In contrast thereto, the second embodiment illustrates a case where a key 202 is supported by a holder 210 that has the same configuration as the holder 10 and a case where a displacement member 207 is displaced by the key 202. The same parts as those in the first embodiment are denoted by the same reference numerals, and the description thereof is omitted.

First, the overall configuration of the keyboard device 201 of the second embodiment will be described with reference to FIG. 11. FIG. 11 is a cross-sectional view of the keyboard device 201 of the second embodiment. FIG. 11 shows a cross section cut along a plane that is orthogonal to the scale direction of the keyboard device 201 (direction in which a plurality of keys 2 are arranged).

As shown in FIG. 11, the keyboard device 201 of the second embodiment includes a chassis 204 supported by a bottom plate 3. The chassis 204 includes a pair of legs 240 separated at a predetermined interval in the front-rear direction, and a support portion 241 connecting the upper ends of the pair of legs 240 in the front-rear direction. The legs 240 and the support portion 241 are integrally formed using synthetic resin, steel plate, or the like, and the holder 210 is fixed to the upper surface of the support portion 241. The holder 210 rotatably supports a plurality of keys 202 (white keys 202a and black keys 202b) arranged in the scale direction.

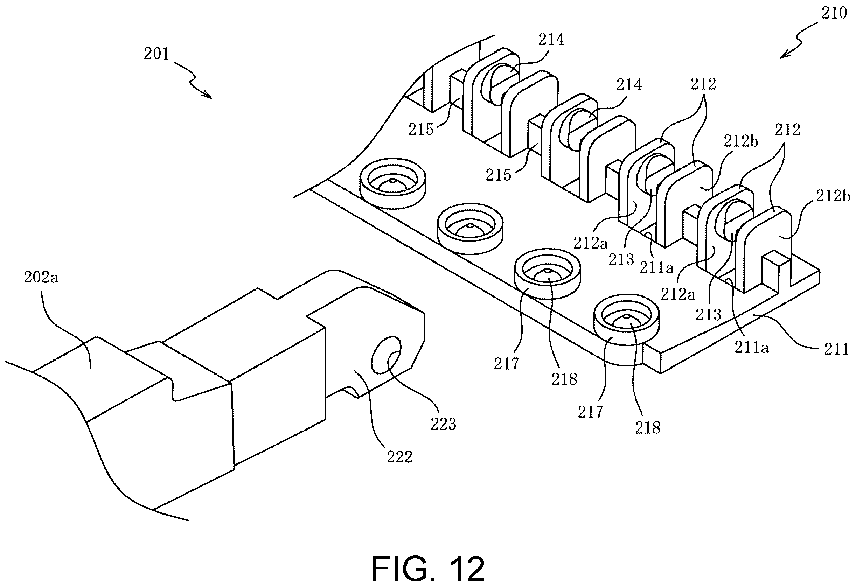

The structure for supporting the keys 2 with the holder 210 will be described with reference to FIG. 11 to FIG. 13A and FIG. 13B. FIG. 12 is an exploded perspective view of the keyboard device 201. FIG. 13A is a partially enlarged cross-sectional view of the keyboard device 201 showing how the shaft portion 213 of the holder 210 is fitted into the insertion hole 223 of the white key 202a, and FIG. 13B is a partially enlarged cross-sectional view of the keyboard device 201 showing a state where the shaft portion 213 of the holder 210 is fitted into the insertion hole 223 of the white key 202a.

As shown in FIG. 11 and FIG. 12, a projecting portion 222 protrudes rearward from the rear end of the white key 202a. The projecting portion 222 is formed in a plate shape having a dimension in the scale direction smaller than the white key 202a (portion to be depressed) (see FIG. 12), and an insertion hole 223 is formed in the projecting portion 222 to penetrate in the scale direction.

The holder 210 includes an attached portion 211 attached to the upper surface of the chassis 204 (support portion 241), a wall portion 212 rising upward from the attached portion 211, and a substantially columnar shaft portion 213 formed on the upper end side of the wall portion 212. These portions 211 to 213 are integrally formed using a resin material (synthetic resin). A plurality of wall portions 212 are arranged in the scale direction, and the projecting portion 222 of the white key 202a is rotatably supported between the plurality of wall portions 212 facing each other.

In the following description, among the side surfaces (surfaces facing the scale direction) of the wall portion 212, the side surface sandwiching the projecting portion 222 is referred to as an inner side surface 212a of the wall portion 212 (see FIG. 12) and the side surface opposite to the inner side surface 212a is referred to as an outer side surface 212b. The shaft portion 213 protrudes in the scale direction from the inner side surface 212a of the wall portion 212.

Since the attached portion 211 is formed in a plate shape extending in the scale direction, the illustration is omitted, and the attached portion 211 can be bent in a state before the holder 210 is fixed to the support portion 241 (see FIG. 11) of the chassis 204. By bending the attached portion 211, the interval between the shaft portions 213 formed on the wall portions 212 is slightly widened, which allows the pair of shaft portions 213 to be easily inserted into the insertion hole 223 of the white key 202a when attaching the white key 202a to the holder 210, as shown in FIG. 13A. Thus, the workability of attaching the white key 202a can be improved.

Furthermore, after attaching the white key 202a to the holder 210, the holder 210 is fixed to the chassis 204 (support portion 241) that has higher rigidity than the holder 210 (attached portion 211), as shown in FIG. 13B, thereby suppressing the attached portion 211 from bending. Since the interval between the shaft portions 213 facing each other is suppressed from widening, the shaft portions 213 can be prevented from coming off from the insertion hole 223 of the white keys 202a. Therefore, the white key 202a can be prevented from coming off from the holder 210.

In addition, since the attached portion 211 has a through hole 211a formed between the wall portions 212 that face each other with the projecting portion 222 interposed therebetween, the attached portion 211 is easily bent, which allows the pair of shaft portions 213 to be easily inserted into the insertion hole 223 of the white key 202a.

In this embodiment, the attached portion 211 is formed in a substantially flat plate shape, but the attached portion 211 may be formed with unevenness (for example, rib-like protrusions). That is, the shape of the attached portion 211 can be appropriately set if the configuration allows the attached portion 211 to be bent, and is not limited to a flat plate shape.

When inserting the projecting portion 222 of the white key 202a between the shaft portions 213, the insertion is guided by the inclined surfaces 224 formed on the projecting portion 222 and the inclined surfaces 214 formed on the shaft portions 213. The inclined surfaces 224 are formed in pair at both ends in the scale direction of the lower surface of the projecting portion 222, and the pair of inclined surfaces 224 are inclined upward and outward in the scale direction.

Besides, the inclined surface 214 of the shaft portion 213 is inclined upward so that the upper end of the tip surface of the shaft portion 213 is obliquely cut (away from the opposing shaft portion 213). That is, because the inclined surface 214 of the shaft portion 213 is inclined in a direction corresponding to the inclined surface 224 of the white key 202a, the inclined surfaces 214 and 224 slide against each other when the projecting portion 222 of the white key 202a is inserted between the pair of shaft portions 213 from above. Due to the sliding, the wall portions 212 are elastically deformed to automatically increase the interval between the pair of shaft portions 213 facing each other, so that the shaft portions 213 can be easily inserted into the insertion hole 223 of the white key 202a.

The attachment of the white key 202a to the holder 210 is completed by inserting the pair of shaft portions 213 into the insertion hole 223. Since the outer side surfaces 212b of the wall portions 212 are connected to each other by the connecting portion 215, the connecting portion 215 can restrict the widening of the interval between the wall portions 212 after the holder 210 is attached to the chassis 204 (support portion 241). Therefore, the white key 202a can be prevented from coming off from the holder 210.

The connecting portion 215 connects the outer side surfaces 212b of the wall portions 212 below the shaft portion 213 (on the side of the attached portion 211), and a gap is formed between the outer side surfaces 212b in the region where the shaft portion 213 is formed (the position overlapping the shaft portion 213 in the scale direction). As a result, the wall portion 212 is allowed to elastically deform moderately. Thus, this embodiment is capable of preventing the attached white key 202a from coming off from the holder 210 while facilitating the attachment of the white key 202a to the holder 210.

A cylindrical holding wall 217 for holding a coil spring 216 is formed on the upper surface of the front end side of the attached portion 211, and a plurality of holding walls 217 are arranged in the scale direction. A conical convex portion 218 that protrudes upward is formed in the central portion of the inner peripheral side of each holding wall 217.

A concave portion 225 (see FIG. 11) is formed on the lower surface of the white key 202a at a position facing the holding wall 217 vertically, and a conical convex portion 226 that protrudes downward is formed on the inner peripheral side of the concave portion 225. The coil spring 216 is sandwiched from above and below by the convex portion 218 of the attached portion 211 and the convex portion 226 of the white key 202a to be held on the inner peripheral side of the holding wall 217 and the concave portion 225.

The elastic force of the coil spring 216 gives a feel of key depression when the white key 202a is depressed while the elastic recovery force of the coil spring 216 returns the white key 202a to the initial position when the key is released. The displacement member 207 interlocks with the rotation of the white key 202a around the shaft portion 213 during such key depression and key release. A detailed configuration for interlocking the displacement member 207 will be described with reference to FIG. 14A and FIG. 14B.

FIG. 14A is a partially enlarged cross-sectional view of the keyboard device 201 in which the part XIVa in FIG. 11 is enlarged, and FIG. 14B is a partially enlarged cross-sectional view of the keyboard device 201 showing a state where the white key 202a is depressed to the terminal position from the state shown in FIG. 14A.

As shown in FIG. 14A, a protrusion portion 228 protrudes downward from the lower surface of the white key 202a, and a guide pin 229 protrudes from the side surface of the protrusion portion 228 in the scale direction. The protrusion portion 228 and the guide pin 229 are integrally formed with the white key 202a.

The guide pin 229 is slidably engaged with a groove 270 formed in the displacement member 207. An insertion hole 271 is formed in the displacement member 207 to penetrate in the scale direction, and the displacement member 207 is rotatably supported by the holder 10 by inserting the shaft portion 13 of the holder 10 into the insertion hole 271. The substrate 9 to which the holder 10 is fixed is supported by the bottom plate 3.

The displacement member 207 is rotated with respect to the shaft portion 13 by the sliding between the guide pin 229 of the white key 202a and the groove 270 formed in the displacement member 207. An upper slide surface 270a and a lower slide surface 270b of the groove 270 are formed parallel (a straight line shape).

In the initial state before the white key 202a is depressed, each of the slide surfaces 270a and 270b of the groove 270 extends to intersect the displacement trajectory of the guide pin 229 around the shaft portion 213 (see FIG. 11).

Thus, as shown in FIG. 14B, when the guide pin 229 rotates around the shaft portion 213 (see FIG. 11) during key depression, the lower slide surface 270b is pushed downward by the guide pin 229. As a result, the displacement member 207 rotates around the shaft portion 13, and along with this rotation, the amount of penetration of the detected portion 208 into the detection region facing the coil 90 increases.

On the other hand, when the white key 202a is released, the elastic recovery force of the coil spring 216 (see FIG. 11) causes the guide pin 229 to rotate around the shaft portion 213 (see FIG. 11) to return to the initial state. Due to the rotation of the guide pin 229, the upper slide surface 270a is pushed up by the guide pin 229, causing the displacement member 207 to rotate around the shaft portion 13 and the amount of penetration of the detected portion 208 into the detection region to decrease.

Also, in this embodiment, the detected portion 208 is provided on the displacement member 207 interlocking with the white key 202a. Because the displacement member 207 can be formed smaller than the white key 202a and the hammer 6 (see FIG. 1), each displacement member 207 is less likely to have dimensional errors. Besides, because the displacement member 207 is axially supported by the relatively small holder 10 attached to the substrate 9 instead of the chassis 204, errors in attaching each displacement member 207 are less likely to occur. Thus, the clearance between the coil 90 and the detected portion 208 is easily set to dimensions according to the designed values for each key 202, which enables the key depression information of each key 202 to be detected with high accuracy.

In addition, if the configuration allows the guide pin 229 of the white key 202a and the groove 270 of the displacement member 207 to be engaged, that is, the configuration allows the displacement member 207 to rotate in conjunction with the white key 202a, the shape of the displacement member 207 and the arrangement of the rotating shaft (shaft portion 13) can be changed freely. That is, by appropriately setting the shape of the displacement member 207 and the position of the rotating shaft, the arrangement of the coil 90 can also be changed to a desired position. Thus, the flexibility in designing the keyboard device 1 is improved.

The detected portion 208 includes a facing portion 280 that covers the bottom surface 272 of the displacement member 207 (facing the coil 90), and a front surface portion 281 that is connected to the front end of the facing portion 280 and covers the front surface 273 of the displacement member 207. Accordingly, when the detected portion 208 starts to enter the detection region, the concentration of the lines of magnetic force can be dispersed at the connection portion between the facing portion 280 and the front surface portion 281 and the upper edge 281a of the front surface portion 281 (achieve the same effects as in FIG. 5B). Since sensor output without an overshoot is obtained, the key depression information can be detected with high accuracy.

**In** addition, since the front surface 273 of the displacement member 207 is covered by the front surface portion 281 that rises from the facing portion 280 of the detected portion 208, a large vertical width of the front surface portion 281 can be ensured even if the thickness of the detected portion 208 is reduced. That is, since the configuration is capable of suppressing an overshoot of sensor output without using a thick metal plate as in the conventional technique, the key depression information can be accurately detected while suppressing an increase in the weight and cost of the keyboard device 201.

The detected portion 208 has the facing portion 280 and the front surface portion 281 formed by bending a single metal plate. Although the illustration is omitted, the detected portion 208 is not provided on a pair of side surfaces (surfaces facing the direction perpendicular to the paper surface of FIG. 14A and FIG. 14B) of the displacement member 207. Accordingly, the detected portion 208 can be easily formed by joining (adhering) the bent metal plate to the bottom surface 272 and the front surface 273 of the displacement member 207.

The method for attaching the displacement member 207 to the holder 10 in this embodiment is the same as the method in the first embodiment described above. Although the illustration is omitted, the interval between the shaft portions 13 facing each other can be widened by bending the attached portion 11 (see FIG. 4A to FIG. 4C) when attaching the displacement member 207 to the holder 10, which allows the pair of shaft portions 13 to be easily inserted into the insertion hole 271 of the displacement member 207.

Furthermore, after attaching the displacement member 207 to the holder 10, the holder 10 is fixed to the substrate 9 that has higher rigidity than the holder 10 (attached portion 11), thereby suppressing the interval between the shaft portions 13 of the wall portions 12 from widening (suppressing the attached portion 11 from bending). Thus, this embodiment is capable of preventing the displacement member 7 from coming off from the holder 10.

Next, a keyboard device 301 of the third embodiment will be described with reference to FIG. 15A, FIG. 15B, FIG. 16A, and FIG. 16B. The above-described first and second embodiments illustrate a case where the displacement members 7 and 207 are rotated by the hammer 6 and the white key 202a, but the third embodiment illustrates a configuration for linearly moving the displacement member 307. The same parts as those in the above-described embodiment are denoted by the same reference numerals, and the description thereof is omitted.

FIG. 15A is a partially enlarged cross-sectional view of the keyboard device 301 of the third embodiment, and FIG. 15B is a partially enlarged cross-sectional view of the keyboard device 301 along the line XVb-XVb in FIG. 15A. FIG. 16A is a partially enlarged cross-sectional view of the keyboard device 301 showing a state where the white key 2a is depressed from the state in FIG. 15A, and FIG. 16B is a partially enlarged cross-sectional view of the keyboard device 301 showing a state where the white key 2a is depressed to the terminal position from the state in FIG. 16A. FIG. 15B shows only the main parts of the keyboard device 301.

As shown in FIG. 15A and FIG. 15B, in the keyboard device 301 of the third embodiment, a substrate 9 along the vertical direction is fixed to a chassis 4. A coil 90 is printed on the rear surface (surface on the right side of FIG. 15A and FIG. 15B) of the substrate 9, and a holder 310 is provided above the coil 90.

The holder 310 includes a flat plate-shaped attached portion 311 that is attached to the substrate 9, and a holding portion 312 that slidably holds the displacement member 307 on the rear surface of the attached portion 311. These portions 311 and 312 are integrally formed using a resin material (synthetic resin).

A plurality of holding portions 312 are arranged in the scale direction, and each holding portion 312 includes a pair of extending portions 312a (see FIG. 15B) extending rearward from the rear surface of the attached portion 311, and bent portions 312b bent toward the space between the pair of extending portions 312a.

A pair of guided portions 370 extend in the scale direction from the front end (the end on the left side in FIG. 15B) of the displacement member 307, and the displacement member 307 is formed in a T shape when viewed from above. In the holding portion 312, a holding space that has a T shape when viewed from above is formed by the extending portions 312a and the bent portions 312b, and the displacement member 307 is inserted from the open portion on the upper side (upper side in FIG. 15A) of the holding space, which allows the displacement member 307 to be slidably held by the holding portion 312.

In the T-shaped holding space of the holding portion 312, the lower end side of the space for holding the guided portions 370 of the displacement member 307 is closed by a wall (not shown), and the displacement member 307 is prevented from falling downward by the engagement between the wall and the guided portions 370.

A pair of upper and lower projecting pieces 371 protrude rearward from the rear surface of the displacement member 307, and an upper slide surface 372a and a lower slide surface 372b of the groove 372 are formed by the pair of projecting pieces 371. A guide pin 65 of the hammer 6 is inserted between the slide surfaces 372a and 372b.

The upper slide surface 372a and the lower slide surface 372b of the groove 372 are formed parallel (a straight line shape). In the initial state before the white key 2a is depressed, each of the slide surfaces 372a and 372b of the groove 372 extends to intersect the displacement trajectory of the guide pin 65 around the rotating shaft 60.

Thus, as shown in FIG. 16A and FIG. 16B, when the guide pin 65 rotates around the rotating shaft 60 during key depression, the lower slide surface 372b is pushed downward by the guide pin 65. As a result, the displacement member 307 slides and displaces downward along the holding portion 312 of the holder 310. On the other hand, when the white key 2a is released, the upper slide surface 372a is pushed up by the guide pin 65 so that the displacement member 307 slides and displaces upward along the holding portion 312. Due to the vertical sliding displacement of the displacement member 307, the amount of penetration of the detected portion 308 into the detection region increases or decreases.

Thus, this embodiment also has a configuration in which the detected portion 308 is provided on the displacement member 307 that interlocks with the rotation of the white key 2a or the hammer 6. Because the displacement member 307 can be formed smaller than the white key 2a and the hammer 6, each displacement member 307 is less likely to have dimensional errors. Besides, because the displacement member 307 is slidably supported by the relatively small holder 310 attached to the substrate 9 instead of the chassis 4, errors in attaching each displacement member 307 are less likely to occur. Thus, the clearance between the coil 90 and the detected portion 308 is easily set to dimensions according to the designed values for each key 2, which enables the key depression information of each key 2 to be detected with high accuracy.

In addition, if the configuration allows the guide pin 65 of the hammer 6 and the groove 372 of the displacement member 307 to be engaged, that is, the configuration allows the displacement member 307 to slide in conjunction with the hammer 6, the shape of the displacement member 307, etc. can be changed freely. That is, by appropriately setting the shape of the displacement member 307, etc., the arrangement of the coil 90 (substrate 9) can also be changed to a desired position. Thus, the flexibility in designing the keyboard device 301 is improved.

The detected portion 308 includes a facing portion 380 that covers the front surface of the displacement member 307 to face the coil 90, and a bottom surface portion (front surface portion) 381 that is connected to the facing portion 380 and covers the bottom surface (outer surface of the displacement member 307 which faces the front side in the displacement direction) of the displacement member 307. Accordingly, as in the embodiments described above, sensor output without an overshoot is obtained without using a thick metal plate.

Further, the detected portion 308 has the facing portion 380 and the bottom surface portion 381 formed by bending a single metal plate. Although the illustration is omitted, the detected portion 308 is not provided on a pair of side surfaces (surfaces facing the direction perpendicular to the paper surface of FIG. 16A and FIG. 16B) of the displacement member 307. Accordingly, the detected portion 308 can be easily formed by joining (adhering) the bent metal plate to the bottom surface and the facing surface of the displacement member 307.

Although the present invention has been described based on the above embodiments, the present invention is by no means limited to the above embodiments, and it can be easily inferred that various modifications and improvements are possible without departing from the gist of the present invention.

Part or all of each of the above embodiments may be combined with or exchanged with part or all of other embodiments. Thus, for example, the support structure for the white key 202a of the second embodiment and the configuration of the detected portion 208 may be applied to the keyboard device 1 of the first embodiment, and the linearly moving displacement member 307 of the third embodiment may be applied to the keyboard device 201 of the second embodiment. Also, as described with reference to FIG. 9A and FIG. 10A as a modified example of the first embodiment, the displacement modes (sensor output of the coil 90) of the displacement members 207 and 307 may be adjusted by changing the shape of the groove 270 of the displacement member 207 of the second embodiment and the shape of the groove 372 of the displacement member 307 of the third embodiment.

Although the above embodiments illustrate a case where the white keys 2a and 202a (keys 2 and 202) are rotatably (swingably) supported by the rotating shaft 20 and the shaft portion 213, the white keys 2a and 202a (keys 2 and 202) may be swingably supported by other known means such as hinges, for example.

Although the above embodiments illustrate the coil 90 as an example of the sensor for detecting the key depression information of the white keys 2a and 202a (keys 2 and 202), the present invention is not necessarily limited thereto. For example, a sensor that detects the key depression information based on a change in electrostatic capacitance may be used, or the key depression information may be detected using other known contactless sensors (for example, the sensor described in Japanese Patent Application Laid-Open No. 03-048295) or contact sensors (for example, the switch described in Japanese Patent Application Laid-Open No. 2015-111235).

Although the above embodiments illustrate a case where the grooves 70, 270, and 372 are formed on the side of the displacement members 7, 207, and 307 while the guide pins 65 and 229 are formed on the side of the hammer 6 and the white key 202a, the grooves may be formed on the side of the hammer 6 and the white key 202a and the guide pins may be formed on the side of the displacement members 7, 207, and 307.

Although the above embodiments illustrate a case where a plurality of displacement members 7, 207, and 307 and keys 202 are supported by the holders 10, 210, and 310 extending in the scale direction, the present invention is not necessarily limited thereto. For example, one displacement member 7, 207, or 307 may be supported by one holder 10 or 310, and one white key 202a may be supported by one holder 210. Further, the hammer 6 may be supported by a member corresponding to the holder 10, 210, or 310, and when the keyboard device 1, 201, or 301 is an electronic organ, the member corresponding to the holder 10, 210, or 310 may rotatably support a foot keyboard of the electronic organ.

Although the above embodiments illustrate non-magnetic metal (such as copper) as an example of the material of the detected portions 8, 208, and 308 that change the magnetic field of the coil 90, the material of the detected portions 8, 208, and 308 may be magnetic metal or a conductive material other than metal. That is to say, the material of the detected portions 8, 208, and 308 is not limited as long as it is a conductor that generates an eddy current in response to a change in magnetic field.

Although the above embodiments illustrate a case where the detected portions 8, 208, and 308 are provided on the displacement members 7, 207, and 307, the detected portions 8, 208, and 308 may be provided on other rotating members such as the keys 2 and 202 and the hammer 6.

Although the above embodiments illustrate a case where the front surface portions 81 and 281 and the bottom surface portion 381 of the detected portions 8, 208, and 308 are provided on the outer surfaces of the displacement members 7, 207, and 307 which are directed to the front side in the displacement direction, the present invention is not necessarily limited thereto. For example, portions corresponding to the front surface portions 81 and 281 and the bottom surface portion 381 may be provided by joining a thick metal plate to the facing surfaces (surfaces facing the coil 90) of the displacement members 7, 207, and 307 as in the conventional technique. Further, the front surface portions 81 and 281 and the bottom surface portion 381 of the detected portions 8, 208, and 308 may be omitted, and the detected portions 8, 208, and 308 may be configured only with the facing portions 80, 280, and 380.

Although the first and second embodiments illustrate a case where the shaft portions 13 and 213 are formed on the side of the holders 10 and 210, and the insertion holes 71 and 271 for inserting the shaft portions 13 and 213 are formed on the side of the displacement members 7 and 207, the shaft portions may be formed on the side of the displacement members 7 and 207, and the insertion holes for inserting the shaft portions may be formed on the side of the holders 10 and 210.

Although the first and second embodiments illustrate a case where the insertion holes 71 and 271 are through holes penetrating through the displacement members 7 and 207, the insertion holes 71 and 271 may be recesses (holes) formed in the side surfaces of the displacement members 7 and 207.

Although the first and second embodiments illustrate a case where partial regions of the outer side surfaces 12b and 212b of the wall portions 12 and 212 on the side of the holders 10 and 210 are connected by the connecting portions 15 and 215, the present invention is not necessarily limited thereto. For example, the connecting portions 15 and 215 may connect the entirety of the outer side surfaces 12b and 212b from the upper end to the lower end, or the connecting portions 15 and 215 may be omitted.

Although the first embodiment illustrates a case where the guide groove 76 and the shaft portion 13 are formed with the inclined surfaces 14 and 76c, and the second embodiment illustrates a case where the white key 202a and the shaft portion 213 are formed with the inclined surfaces 224 and 214, these inclined surfaces may be omitted (for example, the groove bottom surface 76b of the guide groove 76 is made flat).

Although the second and third embodiments illustrate a case where the detected portions 208 and 308 are formed by joining bent metal plates, the present invention is not necessarily limited thereto. For example, the detected portions 208 and 308 may be formed by plating.

Although the first embodiment illustrates a case where thin portions (connecting portions 11b and 11c and cutout portion 11g) are formed in the attached portions 11 of the holders 10 and 210, these thin portions may be omitted and the entire attached portion 11 may be formed to have the same thickness as the base portion 11a, or convex portions (for example, rib-like protrusions) that are thicker than the base portion 11a may be formed on the attached portion 11. In other words, the attached portion 11 is not limited to the above configuration as long as the attached portion 11 can be bent.

Although the first embodiment illustrates a case where the front surface 73 and the rear surface 74 of the displacement member 7 are flat surfaces extending in the normal direction from both front and rear ends of the bottom surface 72, the front surface 73 and the rear surface 74 of the displacement member 7 may be inclined with respect to the normal direction of the bottom surface 72. In addition, the front surface 73 and the rear surface 74 of the displacement member 7 may be curved surfaces.

Although the first embodiment illustrates a case where the guide groove 76, the protrusions 77a and 77b, and the guide portion 78 are formed in the displacement member 7, for example, one or more of the configurations of the guide groove 76, the protrusions 77a and 77b, and the guide portion 78 may be omitted. Furthermore, the guide portion 78 may be formed in a straight line shape instead of an arc shape centering on the insertion hole 71.

Although the first embodiment illustrates a case where the vertical width dimension (rising height from the facing portion 80) of the front surface portion 81 of the detected portion 8 is substantially constant, and the upper edge 81a of the front surface portion 81 is formed in a straight line shape along the scale direction, the present invention is not necessarily limited thereto. For example, the upper edge 81a of the front surface portion 81 may have unevenness or a curved portion (for example, the upper edge 81a of the front surface portion 81 may be chevron-shaped).

Although the first embodiment illustrates a case where the facing portion 80, the front surface portion 81, the rear surface portion 82, and the side surface portion 83 of the detected portion 8 are formed by plating, that is, the detected portion 8 is formed by plating a part of the displacement member 7, for example, the detected portion 8 may be formed by plating the entirety (entire surface) of the displacement member 7. Furthermore, the detected portion 8 (the facing portion 80, the front surface portion 81, the rear surface portion 82, and the side surface portion 83) may be formed by joining a metal plate to the displacement member 7. In the case of this configuration, the detected portion 8 may be made of one metal plate, or the detected portion 8 may be made of a plurality of metal plates.

Although the first embodiment illustrates a case where the facing portion 80 and the front surface portion 81 of the detected portion 8 are connected via the curved portion 84, for example, the curved portion 84 may be omitted (the connection portion between the facing portion 80 and the front surface portion 81 is square).

### Reference Signs List

1, 201, 301 keyboard device
7, 207, 307 displacement member
8, 208, 308 detected portion (conductor)
80, 280, 380 facing portion
81, 281 front surface portion
381 bottom surface portion (front surface portion)
82 rear surface portion
83 side surface portion
84 curved portion
90 coil

## Claims

1. A keyboard device (1) comprising a coil (90) generating a magnetic field; a displacement member (7, 207, 307) having an outer surface and displaced at a position facing the coil during key depression; and a conductor (8, 208, 308 provided on the displacement member, **characterized in that** the conductor comprises a facing portion (80, 280, 380) covering the outer surface of the displacement member to face the coil during key depression; and a front surface portion (81, 281, 381) connected to the facing portion and covering an outer surface of the displacement member which is directed to a front side in a displacement direction of the displacement member.

2. The keyboard device according to claim 1, **characterized in that** the conductor comprises a rear surface portion (82) connected to the facing portion and covering an outer surface of the displacement member which is directed to a rear side in the displacement direction; and a pair of side surface portions (83) connected to the rear surface portion and the facing portion and covering a pair of outer surfaces of the displacement member which are directed in a direction orthogonal to the displacement direction.

3. The keyboard device according to claim 1, **characterized in that** the facing portion and the front surface portion are formed by joining a metal plate to the displacement member, and
the conductor is not provided on the pair of outer surfaces of the displacement member which are directed in the direction orthogonal to the displacement direction.

4. The keyboard device according to claim 3, **characterized in that** the facing portion and the front surface portion are formed by bending a single metal plate.

5. The keyboard device according to claim 1, **characterized in that** a height of the front surface portion rising from the facing portion is substantially constant.

6. The keyboard device according to claim 1, **characterized in that** the conductor comprises a curved portion (84) that curves and connects the facing portion and the front surface portion.

7. The keyboard device according to claim 1, **characterized in that** the conductor is formed by plating the displacement member.

8. The keyboard device according to claim 1, **characterized in that** an upper edge of the front surface portion of the conductor is formed in a straight line shape.

9. A key depression information detecting method for detecting key depression information in a keyboard device (1), which comprises a coil (90) generating a magnetic field, and a displacement member (7, 207, 307) having an outer surface and displaced at a position facing the coil during key depression, the key depression information detecting method **characterized in** comprising:
providing a conductor (8, 208, 308) on the displacement member, wherein the conductor comprises a facing portion (80, 280, 380) covering the outer surface of the displacement member to face the coil during key depression, and a front surface portion (81, 281, 381 ) connected to the facing portion and covering an outer surface of the displacement member which is directed to a front side in a displacement direction of the displacement member; and
detecting the key depression information by displacing the conductor relative to the coil through displacement of the displacement member.

10. The key depression information detecting method according to claim 9, **characterized in that** the conductor comprises a rear surface portion (82) connected to the facing portion and covering an outer surface of the displacement member which is directed to a rear side in the displacement direction; and a pair of side surface portions (83) connected to the rear surface portion and the facing portion and covering a pair of outer surfaces of the displacement member which are directed in a direction orthogonal to the displacement direction.

11. The key depression information detecting method according to claim 9, **characterized in that** the facing portion and the front surface portion are formed by joining a metal plate to the displacement member, and
the conductor is not provided on the pair of outer surfaces of the displacement member which are directed in the direction orthogonal to the displacement direction.

12. The key depression information detecting method according to claim 11, **characterized in that** the facing portion and the front surface portion are formed by bending a single metal plate.

13. The key depression information detecting method according to claim 9, **characterized in that** a height of the front surface portion rising from the facing portion is substantially constant.

14. The key depression information detecting method according to claim 9, **characterized in that** the conductor comprises a curved portion (84) that curves and connects the facing portion and the front surface portion.

15. The key depression information detecting method according to claim 9, **characterized in that** the conductor is formed by plating the displacement member.

## Patentansprüche

1. Tastaturvorrichtung (1), umfassend eine Spule (90), die ein Magnetfeld erzeugt; ein Verschiebungselement (7, 207, 307) mit einer Außenfläche, das während einer Tastenbetätigung an einer der Spule gegenüberliegenden Position verschoben wird; und einen Leiter (8, 208, 308), der an dem Verschiebungselement vorgesehen ist,
**dadurch gekennzeichnet, dass**
der Leiter einen gegenüberliegenden Abschnitt (80, 280, 380), der die Außenfläche des Verschiebungselements abdeckt, um während einer Tastenbetätigung der Spule gegenüberliegend zu sein; und einen Vorderflächenabschnitt (81, 281, 381) umfasst, der mit dem gegenüberliegenden Abschnitt verbunden ist und eine Außenfläche des Verschiebungselements abdeckt, die in einer Verschiebungsrichtung des Verschiebungselements zu einer Vorderseite gerichtet ist.

2. Tastaturvorrichtung nach Anspruch 1, **dadurch gekennzeichnet, dass** der Leiter einen Rückflächenabschnitt (82) umfasst, der mit dem gegenüberliegenden Abschnitt verbunden ist und eine Außenfläche des Verschiebungselements abdeckt, die in der Verschiebungsrichtung zu einer Rückseite gerichtet ist; und ein Paar Seitenflächenabschnitte (83), die mit dem Rückflächenabschnitt und dem gegenüberliegenden Abschnitt verbunden sind und ein Paar Außenflächen des Verschiebungselements abdecken, die in einer Richtung senkrecht zu der Verschiebungsrichtung gerichtet sind.

3. Tastaturvorrichtung nach Anspruch 1, **dadurch gekennzeichnet, dass** der gegenüberliegende Abschnitt und der Vorderflächenabschnitt durch Verbinden einer Metallplatte mit dem Verschiebungselement gebildet sind, und
der Leiter nicht auf dem Paar von Außenflächen des Verschiebungselements vorgesehen ist, die in der Richtung senkrecht zu der Verschiebungsrichtung gerichtet sind.

4. Tastaturvorrichtung nach Anspruch 3, **dadurch gekennzeichnet, dass** der gegenüberliegende Abschnitt und der Vorderflächenabschnitt durch Biegen einer einzigen Metallplatte gebildet sind.

5. Tastaturvorrichtung nach Anspruch 1, **dadurch gekennzeichnet, dass** eine Höhe des von dem gegenüberliegenden Abschnitt aufragenden Vorderflächenabschnitts im Wesentlichen konstant ist.

6. Tastaturvorrichtung nach Anspruch 1, **dadurch gekennzeichnet, dass** der Leiter einen gekrümmten Abschnitt (84) umfasst, der sich krümmt und den gegenüberliegenden Abschnitt und den Vorderflächenabschnitt verbindet.

7. Tastaturvorrichtung nach Anspruch 1, **dadurch gekennzeichnet, dass** der Leiter durch Galvanisieren des Verschiebungselements gebildet ist.

8. Tastaturvorrichtung nach Anspruch 1, **dadurch gekennzeichnet, dass** eine Oberkante des Vorderflächenabschnitts des Leiters in einer geradlinigen Form ausgebildet ist.

9. Tastenbetätigungsinformationen-Erfassungsverfahren zum Erfassen von Tastenbetätigungsinformationen in einer Tastaturvorrichtung (1), die eine ein Magnetfeld erzeugende Spule (90) und ein Verschiebungselement (7, 207, 307) mit einer Außenfläche umfasst, das bei Tastenbetätigung an einer der Spule gegenüberliegenden Position verschoben wird, wobei das Tastenbetätigungsinformationen-Erfassungsverfahren **dadurch gekennzeichnet ist, dass** es umfasst:
Bereitstellen eines Leiters (8, 208, 308) an dem Verschiebungselement, wobei der Leiter einen gegenüberliegenden Abschnitt (80, 280, 380), der die Außenfläche des Verschiebungselements abdeckt, um während Tastenbetätigung der Spule gegenüberzuliegen, und einen Vorderflächenabschnitt (81, 281, 381) umfasst, der mit dem gegenüberliegenden Abschnitt verbunden ist und eine Außenfläche des Verschiebungselements abdeckt, die in einer Verschiebungsrichtung des Verschiebungselements zu einer Vorderseite gerichtet ist; und
Erfassen der Tastenbetätigungsinformationen durch Verschieben des Leiters relativ zu der Spule mittels der Verschiebung des Verschiebungselements.

10. Tastenbetätigungsinformationen-Erfassungsverfahren nach Anspruch 9, **dadurch gekennzeichnet, dass** der Leiter einen Rückflächenabschnitt (82) umfasst, der mit dem gegenüberliegenden Abschnitt verbunden ist und eine Außenfläche des Verschiebungselements abdeckt, die in der Verschiebungsrichtung zu einer Rückseite gerichtet ist; und ein Paar Seitenflächenabschnitte (83), die mit dem Rückflächenabschnitt und dem gegenüberliegenden Abschnitt verbunden sind und ein Paar Außenflächen des Verschiebungselements abdecken, die in einer Richtung senkrecht zu der Verschiebungsrichtung gerichtet sind.

11. Tastenbetätigungsinformationen-Erfassungsverfahren nach Anspruch 9, **dadurch gekennzeichnet, dass** der gegenüberliegende Abschnitt und der Vorderflächenabschnitt durch Verbinden einer Metallplatte mit dem Verschiebungselement gebildet werden und
der Leiter nicht auf dem Paar von Außenflächen des Verschiebungselements vorgesehen ist, die in der Richtung senkrecht zu der Verschiebungsrichtung gerichtet sind.

12. Tastenbetätigungsinformationen-Erfassungsverfahren nach Anspruch 11, **dadurch gekennzeichnet, dass** der gegenüberliegende Abschnitt und der Vorderflächenabschnitt durch Biegen einer einzigen Metallplatte gebildet werden.

13. Tastenbetätigungsinformationen-Erfassungsverfahren nach Anspruch 9, **dadurch gekennzeichnet, dass** eine Höhe des von dem gegenüberliegenden Abschnitt aufragenden Vorderflächenabschnitts im Wesentlichen konstant ist.

14. Tastenbetätigungsinformationen-Erfassungsverfahren nach Anspruch 9, **dadurch gekennzeichnet, dass** der Leiter einen gekrümmten Abschnitt (84) umfasst, der sich krümmt und den gegenüberliegenden Abschnitt und den Vorderflächenabschnitt verbindet.

15. Tastenbetätigungsinformationen-Erfassungsverfahren nach Anspruch 9, **dadurch gekennzeichnet, dass** der Leiter durch Galvanisieren des Verschiebungselements gebildet wird.

## Revendications

1. Dispositif de clavier (1), comprenant une bobine (90) générant un champ magnétique ; un élément de déplacement (7, 207, 307) présentant une surface extérieure et se déplaçant vers une position faisant face à la bobine lors de l'enfoncement d'une touche ; et un conducteur (8, 208, 308) prévu sur l'élément de déplacement, **caractérisé en ce que**
le conducteur comprend une partie en regard (80, 280, 380) recouvrant la surface extérieure de l'élément de déplacement de manière à faire face à la bobine lors de l'enfoncement d'une touche ; et une partie de surface avant (81, 281, 381) reliée à la partie en regard et recouvrant une surface extérieure de l'élément de déplacement qui est orientée vers un côté avant dans la direction de déplacement de l'élément de déplacement.

2. Dispositif de clavier selon la revendication 1, **caractérisé en ce que** le conducteur comprend une partie de surface arrière (82) reliée à la partie en regard et recouvrant une surface extérieure de l'élément de déplacement qui est orientée vers un côté arrière dans la direction de déplacement ; et une paire de parties de surface latérales (83) reliées à la partie de surface arrière et à la partie en regard et recouvrant une paire de surfaces extérieures de l'élément de déplacement qui sont orientées dans une direction orthogonale à la direction de déplacement.

3. Dispositif de clavier selon la revendication 1, **caractérisé en ce que** partie en regard et la partie de surface avant sont formées par assemblage d'une plaque métallique à l'élément de déplacement, et
le conducteur n'est pas prévu sur la paire de surfaces extérieures de l'élément de déplacement qui sont orientées dans la direction orthogonale à la direction de déplacement.

4. Dispositif de clavier selon la revendication 3, **caractérisé en ce que** la partie en saillie et la partie de surface avant sont formées par pliage d'une seule plaque métallique.

5. Dispositif de clavier selon la revendication 1, **caractérisé en ce que** la hauteur de la partie de surface avant s'élevant depuis la partie en regard est sensiblement constante.

6. Dispositif de clavier selon la revendication 1, **caractérisé en ce que** le conducteur comprend une partie courbe (84) qui relie, en formant une courbe, la partie en regard et la partie de surface avant.

7. Dispositif de clavier selon la revendication 1, **caractérisé en ce que** le conducteur est formé par placage de l'élément de déplacement.

8. Dispositif de clavier selon la revendication 1, **caractérisé en ce qu'**un bord supérieur de la partie de surface avant du conducteur est formé en ligne droite.

9. Procédé de détection d'informations d'enfoncement de touche destiné à détecter des informations d'enfoncement de touche dans un dispositif de clavier (1), qui comprend une bobine (90) générant un champ magnétique, et un élément de déplacement (7, 207, 307) présentant une surface extérieure et déplacé vers une position faisant face à la bobine lors de l'enfoncement d'une touche, le procédé de détection d'informations d'enfoncement de touche étant **caractérisé en ce qu'**il comprend :
la mise en place d'un conducteur (8, 208, 308) sur l'élément de déplacement, dans lequel le conducteur comprend une partie en regard (80, 280, 380) recouvrant la surface extérieure de l'élément de déplacement de manière à faire face à la bobine lors de l'enfoncement d'une touche, et une partie de surface avant (81, 281, 381) reliée à la partie en regard et recouvrant une surface extérieure de l'élément de déplacement qui est orientée vers un côté avant dans une direction de déplacement de l'élément de déplacement ; et
la détection des informations d'enfoncement de touche par le déplacement du conducteur par rapport à la bobine grâce au déplacement de l'élément de déplacement.

10. Procédé de détection d'informations d'enfoncement de touche selon la revendication 9, **caractérisé en ce que** le conducteur comprend une partie de surface arrière (82) reliée à la partie en regard et recouvrant une surface extérieure de l'élément de déplacement qui est orientée vers un côté arrière dans la direction de déplacement ; et une paire de parties de surface latérale (83) reliées à la partie de surface arrière et à la partie en regard, et recouvrant une paire de surfaces extérieures de l'élément de déplacement qui sont orientées dans une direction orthogonale à la direction de déplacement.

11. Procédé de détection d'informations d'enfoncement de touche selon la revendication 9, **caractérisé en ce que** la partie frontale et la partie de surface avant sont formées en assemblant une plaque métallique à l'élément de déplacement, et
le conducteur n'est pas prévu sur la paire de surfaces extérieures de l'élément de déplacement qui sont orientées dans la direction orthogonale à la direction de déplacement.

12. Procédé de détection d'informations d'enfoncement de touche selon la revendication 11, **caractérisé en ce que** la partie en regard et la partie de surface avant sont formées par pliage d'une seule plaque métallique.

13. Procédé de détection d'informations d'enfoncement de touche selon la revendication 9, **caractérisé en ce que** la hauteur de la partie de surface avant s'élevant depuis la partie en regard est sensiblement constante.

14. Procédé de détection d'informations d'enfoncement de touche selon la revendication 9, **caractérisé en ce que** le conducteur comprend une partie courbe (84) qui relie la partie en regard et la partie de surface avant en formant une courbe.

15. Procédé de détection d'informations d'enfoncement de touche selon la revendication 9, **caractérisé en ce que** le conducteur est formé par placage de l'élément de déplacement.
